Europäisches Patentamt

European Patent Office

Office européen des brevets

(19)

(11) **EP 0 749 233 B1**

(12) **FASCICULE DE BREVET EUROPEEN**

(45) Date de publication et mention
de la délivrance du brevet:
**12.01.2000 Bulletin 2000/02**

(51) Int Cl.⁷: **H04N 3/15**

(21) Numéro de dépôt: **96401275.1**

(22) Date de dépôt: **12.06.1996**

(54) **Dispositif et procédé de numérisation pour détecteurs photosensibles et procédé de lecture d'une matrice de détecteurs photoniques**

Digitalisierungsvorrichtung und -verfahren für lichtempfindliche Detektoren und Ausleseverfahren einer Matrix von Lichtdetektoren

Digitizing device and method for photosensitive detectors and read-out for a matrix of light detectors

(84) Etats contractants désignés:
**DE GB IT SE**

(30) Priorité: **14.06.1995 FR 9507079**

(43) Date de publication de la demande:
**18.12.1996 Bulletin 1996/51**

(73) Titulaire: **COMMISSARIAT A L'ENERGIE ATOMIQUE**
**75015 Paris (FR)**

(72) Inventeurs:
• **Pantigny, Philippe**
**38640 Claix (FR)**
• **Audebert, Patrick**
**38100 Grenoble (FR)**
• **Mottin, Eric**
**38950 St Martin le Vinaux (FR)**
• **Rothan, Frédéric**
**38600 Fontaine (FR)**

(74) Mandataire: **Dubois-Chabert, Guy et al**
**BREVATOME**
**3, rue du Docteur Lanceraux**
**75008 Paris (FR)**

(56) Documents cités:
**WO-A-87/05457**

• **1990 IEEE INTERNATIONAL SYMPOSIUM ON CIRCUITS AND SYSTEMS, no. 3 of 4, 1 - 3 Mai 1990, (US), pages 1705-1708, XP000163546 K.CHEN ET AL.: "PASIC: A Processor-A/D converter-Sensor Integrated Circuit"**

## EP 0 749 233 B1

**Description**

Domaine technique

La présente invention conserne un dispositif de numérisation pour détecteurs photosensibles et un procédé de lecture d'une matrice de détecteurs photoniques.

Etat de la technique antérieure

Le domaine de l'invention est celui des dispositifs de détection de rayonnement, en particulier les rayonnements émis aux longueurs d'ondes de l'infrarouge, du visible et des rayons X.

L'invention se rapporte plus particulièrement à l'utilisation d'une architecture de circuit de lecture spécifique en vue de numériser les signaux issus des détecteurs.

Les capteurs photosensibles fonctionnant dans le spectre allant des rayons X à l'infrarouge sont destinés à l'imagerie ou au traitement d'information en vue notamment d'applications scientifiques. Le signal issu de ce capteur est généralement de type analogique et il est délivré par un amplificateur de sortie. Ce signal est ensuite numérisé en dehors du capteur pour être utilisé dans la chaîne de traitement.

Etat de l'art analogique

Les dispositifs de détection photonique concernés par l'invention sont de deux types :

- quantiques ;
- thermiques.

Dans les détecteurs quantiques, les photons reçus par le détecteur sont convertis en électrons et/ou trous selon le principe de la détection intrinsèque (transition bande de valence à bande de conduction directe) ou extrinsèque (transition entre niveau intermédiaire et bande de conduction). Les détecteurs quantiques peuvent être regroupés en deux catégories :

- les détecteurs photovoltaïques dont l'intensité du courant varie en fonction du flux incident ;
- les détecteurs photoconducteurs dont la résistance varie en fonction du flux incident.

Les détecteurs thermiques peuvent être regroupés en deux catégories :

- les détecteurs bolométriques résistifs, la résistance varie en fonction de l'énergie du rayonnement incident ;
- les détecteurs à diodes, dont l'intensité du courant varie en fonction du flux incident.

Les détecteurs quantiques et les détecteurs thermiques peuvent être chacun assimilé à un générateur de courant, plus ou moins idéal, qui délivre un courant dont l'intensité varie en fonction du flux incident, moyennant que ces détecteurs soient convenablement polarisés.

Dans des caméras intéressantes pour l'invention, les images sont faites soit à partir de barrettes de détecteurs, autrement dit des détecteurs implantés à un pas régulier dans une seule direction, qui doivent être balayées, soit à partir de mosaïques ou matrices, autrement dit des détecteurs implantés de façon matricielle, qui ne sont pas balayées dans la plupart des cas.

Vu le nombre de détecteurs utilisés dans les caméras actuelles, et vu le pas des détecteurs, il est absolument nécessaire d'utiliser un circuit spécifique, que l'on désignera par la suite par circuit de lecture, pour conditionner le signal délivré par le détecteur et le multiplexer vers un nombre restreint de chaînes de traitement de l'information.

Chaque détecteur peut être réalisé soit directement sur le circuit de lecture, soit sur un autre circuit. Dans le premier cas on parle de composant monolithique et dans le deuxième de composant hybride car les détecteurs du circuit de détection sont interconnectés aux étages d'entrée du circuit de lecture par des technologies adaptées comme l'hybridation par billes.

L'invention porte sur une architecture de circuit de lecture particulièrement adaptée à la lecture de mosaïque de :

- détecteurs quantiques réalisés sur un autre substrat que celui du circuit de lecture et, par conséquent, hybridé à ce circuit de lecture ;
- détecteurs thermiques réalisés directement sur le circuit de lecture.

**2**

On va à présent décrire plusieurs circuits de lecture de l'art antérieur.

**Circuits de lecture de type dispositifs à transfert de charges**

Les circuits de lecture de type dispositifs à transfert de charges sont fabriqués dans des filières spécifiques permettant de réaliser des dispositifs à transfert de charges.

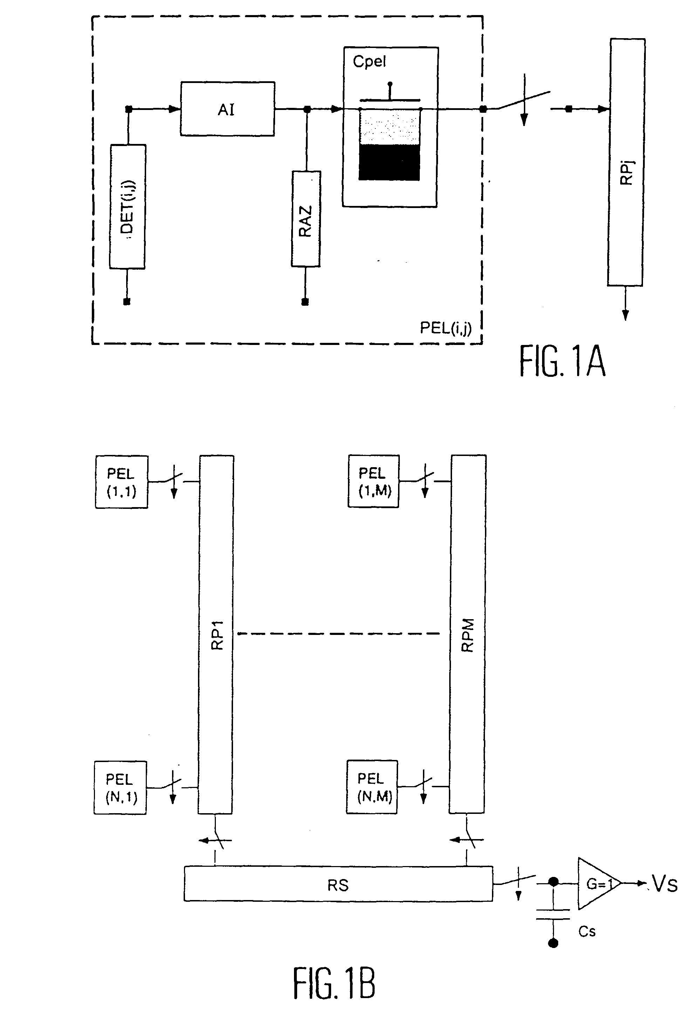

Le schéma de principe de ces circuits est donné sur les figures 1A et1B.

On trouve dans chaque point élémentaire représenté sur la figure 1A :

- un interrupteur ou un dispositif d'adaptation d'impédance AI entre un détecteur et un condensateur MOS ;
- un condensateur MOS Cpel ("Conception de circuits intégrés MOS" aux éditions Eyrolles) dont le canal d'inversion est utilisé comme site de stockage ;
- un interrupteur qui permet de contrôler l'injection des charges stockées dans le point élémentaire dans le canal d'un registre à transfert de charges ;
- un dispositif de remise à zéro (RAZ) du site de stockage.

Le multiplexage des charges stockées dans les points élémentaires vers une ou des sorties se fait au moyen de deux types de registre à transfert de charges :

- les registres parallèles $RP_j$ qui multiplexent les points élémentaires d'une colonne vers une entrée du registre série ;
- le (les) registre(s) séries RS qui multiplexent les charges venant des registres parallèles vers (les) l'étage(s) de sortie du circuit de lecture.

A chaque trame, le canal d'inversion du condensateur d'intégration est vidé de toute charge au moyen du dispositif de remise à zéro. Le courant débité par chaque détecteur de la mosaïque est alors intégré pendant le temps de pose dans le canal d'inversion du condensateur d'intégration.

La charge intégrée $Qpel_{ij}$ dans la capacité de stockage Cpel du point élémentaire PEL(i,j) est reliée à l'intensité $Id_{ij}$ du courant débité par le détecteur DET(i,j) et au temps de pose par la relation :

$$Qpel_{ij} = Id_{ij} \times Tpose$$

Tout ou partie de la charge stockée dans chacun de ces condensateurs d'intégration est alors prélevée par différentes techniques et multiplexée au moyen de dispositifs à transfert de charges vers un (des) étage(s) de sortie. C'est dans l'étage de sortie que les charges sont converties en tension par injection dans une capacité convenablement polarisée. La tension aux bornes de ce condensateur est lue par un amplificateur de tension à très forte impédance d'entrée et à faible impédance de sortie.

L'expression de l'amplitude $\delta Vs_{ij}$ de l'impulsion de tension de sortie, correspondant à la lecture du point élémentaire PEL(i,j), est donnée par l'expression :

$$\delta Vs_{ij} = Aq \times Id_{ij} \times Tpose / Cs$$

où Cs est le facteur de conversion charge tension de l'étage de sortie et Aq le gain en charges du circuit.

Ces circuits de lecture présentent l'avantage d'avoir un temps de pose identique et synchrone pour tous les détecteurs.

En revanche, ils ne sont pas compatibles avec un adressage aléatoire des détecteurs, ce qui interdit de réaliser des sous-images.

Le dispositif de remise à zéro n'est absolument nécessaire que si l'intégralité de la charge intégrée ne peut être transférée dans le registre parallèle.

Ces circuits de lecture présentent enfin l'inconvénient majeur de devoir être réalisés dans des filières spécifiques dont la densité d'intégration est inférieure à celle des filières CMOS classiques alors que le pas des mosaïques de détecteurs se réduit fortement.

**Circuits de lecture de type suiveurs commutés**

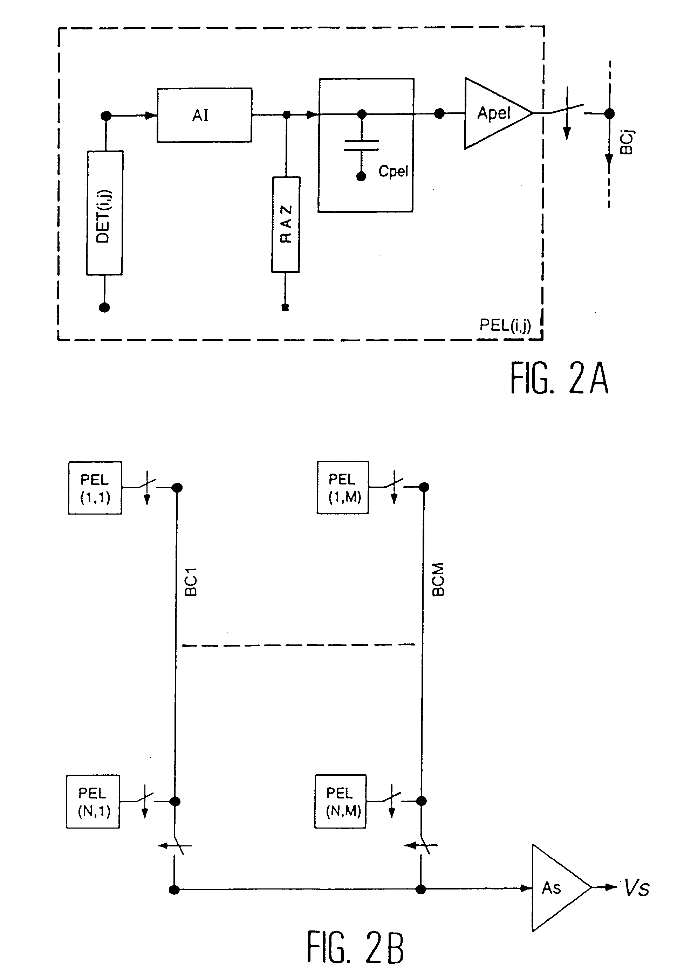

Pour des circuits de lecture de type suiveurs commutés décrits notamment dans les références [1], [2] et [3] citées en fin de description, un schéma de principe est donné sur les figures 2A et 2B.

On trouve au minimum dans chaque point élémentaire représenté sur la figure 2A :

- un interrupteur ou un dispositif d'adaptation d'impédance AI entre un détecteur DET(i,j) et un condensateur d'intégration ;
- un condensateur Cpel réalisé au moyen d'un transistor MOS dont la capacité grille-source permet de convertir le courant en tension par intégration ;
- un interrupteur de réinitialisation du condensateur d'intégration à chaque trame, réalisé au moyen de transistors MOS ;
- un amplificateur de tension Apel à forte impédance d'entrée qui permet de lire la tension aux bornes du condensateur d'intégration et d'attaquer à basse impédance un amplificateur de sortie ;
- un interrupteur qui permet de commuter la sortie de l'amplificateur du point élémentaire sur une connexion commune aux points élémentaires d'une même colonne, dite bus colonne BCj.

Le multiplexage des bus colonnes BCj vers un ou plusieurs amplificateurs de sortie As se fait au moyen d'interrupteurs implantés aux extrémités de chaque bus colonne.

A chaque trame, la tension aux bornes du condensateur d'intégration est tout d'abord réinitialisée au moyen de l'interrupteur de remise à zéro. Le courant du détecteur est alors intégré dans le condensateur d'intégration pendant une durée Tpose. A la fin du temps d'intégration, la sortie de l'amplificateur du point élémentaire est commutée sur le bus colonne et sur l'amplificateur de sortie au moyen des interrupteurs du point élémentaire et du multiplexeur ligne convenablement séquencés.

L'expression de la variation de tension, $\delta Vpel_{ij}$, aux bornes du condensateur d'intégration du point élémentaire PEL(i,j) en fonction du courant, $Id_{ij}$ du détecteur DET(i,j) de ce point élémentaire est donnée par l'expression :

$$\delta Vpel_{ij} = Id_{ij} \times Tpose / Cpel$$

où la Cpel est la capacité du condensateur de stockage du point élémentaire.

La variation de la tension de sortie, $\delta Vpel_{ij}$, correspondant à la lecture du point élémentaire PEL(i,j) est donnée par la relation :

$$\delta Vs_{ij} = Apel \times As \times \delta Vpel_{ij} = Apel \times As \times Id_{ij} \times Tpose / Cpel$$

où Apel (respectivement As) est le gain en tension de l'amplificateur de tension du point élémentaire (respectivement de l'amplificateur de sortie).

Ce type d'architecture de circuit présente l'avantage d'être compatible avec un adressage aléatoire des points élémentaires, autrement dit la réalisation de sous-images.

Une première limitation est liée au mode de lecture des détecteurs. En effet, dans le cas où le temps de pose doit être identique et synchrone pour tous les détecteurs, il faut échantillonner-bloquer la tension aux bornes du condensateur de stockage dans le point élémentaire. Cette fonction impose alors des contraintes supplémentaires dans la conception du point élémentaire qu'il sera d'autant plus difficile à satisfaire que le pas du point élémentaire est petit. En particulier, la surface du condensateur de stockage, donc sa capacité, diminue. La réduction de la charge stockable se traduit alors par une dégradation du rapport signal sur bruit.

Une autre limitation de ce type d'architecture est liée à la cadence de lecture qui impose des contraintes de dimensionnement à l'amplificateur de tension du point élémentaire et à l'interrupteur qui permet la connexion entre les sorties des points élémentaires d'une même colonne à l'amplificateur de sortie. En effet, le temps d'établissement du signal en sortie de l'amplificateur du point élémentaire doit être inférieur à la période de sortie du signal vidéo. Il faut pratiquement :

- que l'amplificateur du point élémentaire soit capable de fournir un courant élevé ;
- que la résistance de l'interrupteur soit suffisamment faible pour ne pas diminuer de manière significative le gain en tension de l'amplificateur ;
- que le couplage capacitif dû au point diviseur entre la capacité entrée-sortie de l'amplificateur du point élémentaire et la capacité de stockage soit tel que la tension échantillonnée-bloquée sur l'entrée de l'amplificateur du point élémentaire ne soit pas modifiée de manière significative.

Ces contraintes sont d'autant plus difficiles à satisfaire que le nombre de détecteurs augmente et que le pas des points élémentaires diminue alors que la cadence image reste constante et que le nombre de sorties a plutôt tendance à diminuer.

Enfin, il faut absolument intégrer dans le point élémentaire un dispositif spécifique, pour remplir la fonction de remise à zéro du point élémentaire, ce qui nécessite au moins un transistor de plus.

**Circuits de lecture de type partition bus colonne**

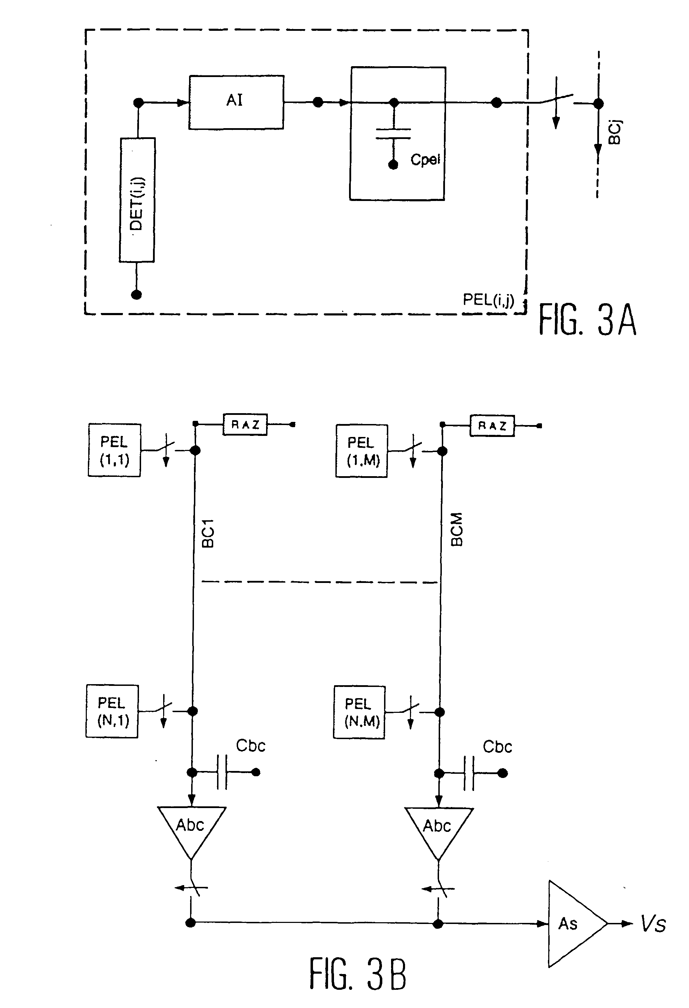

Pour des circuits de lecture de type partition bus colonne, un schéma de principe est donné sur les figures 3A et 3B.

On trouve au minimum dans chaque point élémentaire représenté sur la figure 3A :

- un interrupteur ou un dispositif d'adaptation d'impédance AI entre un détecteur DET(i,j) et un condensateur d'intégration ;
- un condensateur Cpel dont la capacité, soit celle du canal d'inversion d'un condensateur MOS, soit la capacité grille-source d'un transistor MOS, permet de convertir le courant en tension par intégration ;
- un interrupteur qui permet de commuter une borne du condensateur d'intégration du point élémentaire sur une connexion commune aux points élémentaires d'une même colonne, dite bus colonne BCj.

Un amplificateur Abc de tension à forte impédance d'entrée, mais à faible capacité d'entrée, est implanté en bout de chaque bus colonne BCj, ainsi qu'un interrupteur de remise à zéro des condensateurs d'intégration.

Le multiplexage des sorties de ces amplificateurs de tension vers un ou plusieurs amplificateurs de sortie As se fait au moyen d'interrupteurs implantés à la sortie de chacun de ces amplificateurs.

Le multiplexage des sorties de ces amplificateurs de tension vers un ou plusieurs amplificateurs de sortie se fait au moyen d'interrupteurs implantés à la sortie de chacun de ces amplificateurs.

A chaque trame, le courant du détecteur est intégré dans le condensateur d'intégration pendant une durée Tpose. A la fin du temps d'intégration, une ligne est sélectionnée et les interrupteurs des points élémentaires de cette ligne sont fermés sur les bus d'interconnexion qui ont été préalablement convenablement initialisés. Le système formé par le condensateur de stockage et le bus colonne étant isolé, la tension finale du bus colonne est fonction de sa capacité et de celle de stockage. Dès que cette tension est stabilisée, la tension de sortie des amplificateurs de colonnes est multiplexée vers le (les) amplificateur(s) de sortie. Il est alors possible de réinitialiser le condensateur d'intégration d'une même ligne au moyen des interrupteurs de remise à zéro situés à l'extrémité de chaque bus colonne.

La charge $Qpel_{ij}$ intégrée dans le point élémentaire PEL(i,j) en fonction du courant, $Id_{ij}$ du détecteur de ce point élémentaire et du temps de pose Tpose est donnée par l'expression :

$$Qpel_{ij} = Id_{ij} \times Tpose$$

La variation de tension, $\delta Vbc_{ij}$, du bus colonne après commutation du condensateur du point élémentaire PEL(i,j) est obtenue en écrivant l'équation de la conservation de charge (on suppose ici que la charge initiale sur le bus colonne est nulle) :

$$\delta Vbc_{ij} = Qpel_{ij} / (Cpel+Cbc) = Id_{ij} \times Tpose / (Cpel+Cbc)$$

où Cpel (respectivement Cbc) est la capacité du condensateur de stockage dans le point élémentaire (respectivement capacité du bus colonne).

La variation de tension de sortie, $\delta Vbc_{ij}$, correspondant à la lecture de l'information délivrée par le point élémentaire PEL(i,j) est donnée par la relation suivante :

$$\delta Vs_{ij} = As \times Abc \times \delta Vbc_{ij} = As \times Abc \times Id_{ij} \times Tpose / (Cpel+Cbc)$$

où Abc (respectivement As) est le gain en tension de l'amplificateur de tension d'un bus colonne (respectivement de l'amplificateur de sortie).

Les avantages et les inconvénients de cette architecture sont quasiment les mêmes que ceux de la structure à suiveurs commutés, à la différence près que les inconvénients liés à la présence de l'amplificateur disparaissent. Quant à la remise à zéro du point élémentaire, il n'est pas absolument nécessaire d'implanter dans le point élémentaire un dispositif spécifique car il est possible de réinitialiser le condensateur d'intégration via le bus colonne.

Il faut cependant que l'utilisateur s'accommode de la réduction de gain due à l'atténuation du signal contrôlée par la valeur de la capacité du bus colonne. Ce point peut être rédhibitoire en terme de rapport signal sur bruit pour des circuits de grand format, donc à Cbc élevé, et/ou pour des applications où la charge à manipuler est petite.

**Circuits de lecture de type intégration déportée**

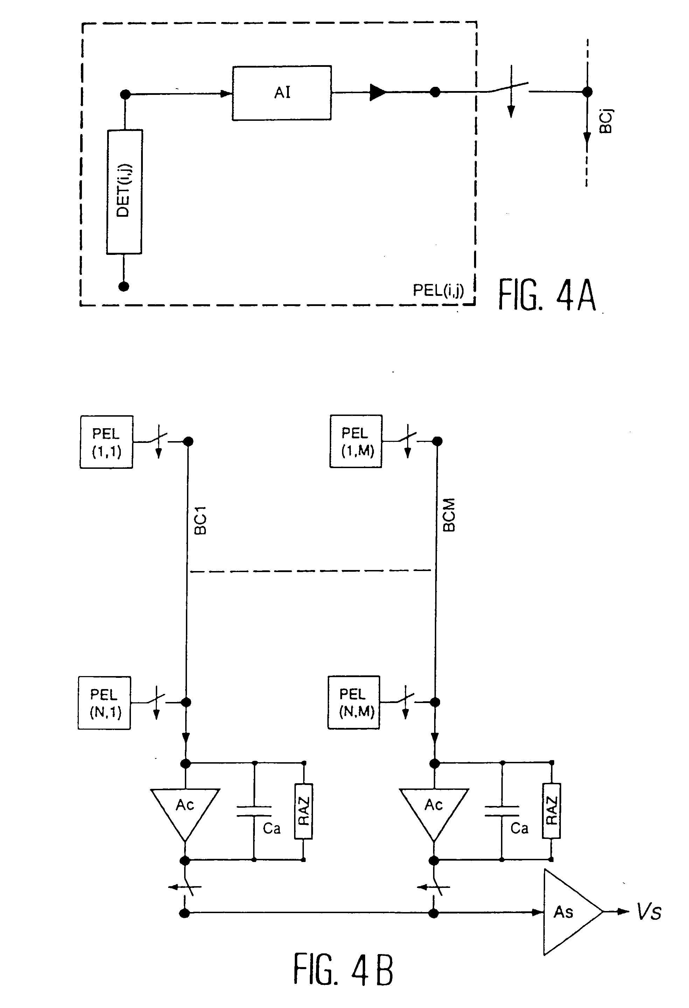

Pour des circuits de lecture de type intégration déportée, tels que décrits notamment dans les références [4] et [5] citées en fin de description, un schéma de principe est donné sur les figures 4A et 4B.

Dans chaque point élémentaire on trouve au minimum, car le dispositif d'adaptation d'impédance AI n'est pas toujours absolument nécessaire, un interrupteur qui permet de commuter le détecteur DET(i,j) sur une connexion commune aux points élémentaires d'une même colonne, dite bus colonne BCj. Puis, à l'extrémité de chaque colonne, on trouve un amplificateur de charges Ac, c'est-à-dire un amplificateur de tension contre-réactionné par un condensateur.

Le multiplexage des sorties de ces amplificateurs de charges Ac vers un ou plusieurs amplificateurs de sortie As se fait au moyen d'interrupteurs implantés à la sortie de chacun de ces amplificateurs de charges.

A chaque trame, les lignes de détecteurs sont sélectionnées les unes après les autres. Au moment voulu, les détecteurs de la ligne adressée sont commutés sur les bus colonnes en fermant les interrupteurs implantés dans les points élémentaires de la ligne considérée, pendant une durée égale au temps de pose (Tpose).

Le courant $Id_{ij}$ délivré par le détecteur DET(i,j) est intégré pendant Tpose par l'amplificateur de charges connecté au bus colonne BCj. A la fin du temps de pose, la tension de sortie de l'amplificateur de charge est lue par la chaîne d'acquisition. Une autre ligne peut alors être sélectionnée après que les amplificateurs de charges ont été convenablement réinitialisés.

La variation de tension de sortie $\delta Vc_{ij}$ de l'amplificateur de charge Acj sur lequel a été commuté le détecteur DET(i,j) est donnée par la formule :

$$\delta Vc_{ij} = Id_{ij} \times Tpose / Ca$$

où Ca est la capacité du condensateur de contre-réaction de l'amplificateur de charges.

La variation de tension de sortie $\delta Vs_{ij}$ correspondant à la lecture de l'information délivrée par le point élémentaire PEL(i,j) est donnée par la relation suivante :

$$\delta Vs_{ij} = As \times \delta Vc_{ij} = As \times Id_{ij} \times Tpose / Ca$$

où As est le gain en tension de l'amplificateur de tension de sortie.

Cette architecture ne nécessite qu'un interrupteur par point élémentaire, d'où son domaine d'application dans les mosaïques à pas réduit. En particulier un interrupteur de remise à zéro n'est pas indispensable dans le point élémentaire.

Par contre, il est clair que ce type d'architecture n'est pas compatible avec un temps de pose identique et synchrone pour tous les points élémentaires.

Par ailleurs, cette architecture impose une contrainte sur le temps de pose qui doit être inférieur ou égal à la période du signal de sortie vidéo divisé par le nombre de lignes à lire. Cette contrainte limite le rapport signal sur bruit de ce type de circuit de lecture pour des applications à grand nombre de points et à nombre de sorties réduites.

Etat de l'art de la conversion analogique-numérique dans les plans focaux

Une limitation des performances de ces capteurs en terme de rapport signal sur bruit provient de la transmission du signal analogique en dehors du plan focal.

De plus le traitement de l'information est plus aisé à réaliser en numérique qu'en analogique. Par exemple, un signal numérique dans le plan focal permet d'envisager plus aisément des réalisations telles que le TDI (Time Delay Integration) ou le moyennage en vue d'accroître le rapport signal à bruit.

La conversion analogique-numérique dans un plan focal est envisagée en implantant directement un ou plusieurs convertisseurs dans le plan focal (voir références [7] et [8]). Les principales limitations à cette solution viennent de la consommation électrique, de la taille de la puce, de la résolution et de la vitesse de conversion du (ou des) convertisseur(s), de la complexité technologique et du coup de développement d'une telle architecture qui peut nécessiter dans certains cas l'emploi de "Z technologie" (voir référence [9]).

Il existe une grande variété de convertisseurs. On peut citer par exemple :

- les convertisseurs "flash" ;
- les convertisseurs "à approximation successive" ;
- les convertisseurs "à simple ou double rampe" ;
- les convertisseurs "sigma-delta".

L'utilisation de ces convertisseurs s'envisage généralement en utilisation parallèle où l'on dispose d'un convertisseur en bout de chaque colonne de l'imageur comme illustré dans WO-A-8705457. Hormis le cas d'un signal ayant une dynamique de sortie supérieure aux dynamiques analogiques gérables en sortie d'un plan focal, un convertisseur unique dans le plan focal ne sera jamais une alternative performante par rapport à la conversion hors plan focal en terme de vitesse, de résolution et de consommation électrique.

Etant donné le peu de place et la faible consommation électrique tolérable dans un plan focal ces convertisseurs sont souvent inadaptés à la conversion numérique dans un capteur d'imagerie.

L'invention a pour objet un dispositif et un procédé de lecture de détecteurs photosensibles permettant de réaliser la conversion analogique-numérique sur chaque détecteur photosensible en s'affranchissant des problèmes d'encombrement et de consommation dus au(x) convertisseur(s).

Exposé de l'invention

La présente invention concerne un dispositif de lecture d'une matrice de détecteurs photosensibles, qui délivre un courant dont l'intensité varie en fonction du flux incident, le temps de pose étant identique et synchrone pour tous les détecteurs, caractérisé en ce qu'il comprend un ensemble de points élémentaires permettant de lire les signaux délivrés par chaque détecteur, chaque point élémentaire réalisant une préintégration du courant délivré par un détecteur correspondant de façon à générer une quantité de charge. Une lecture de la quantité de charges résultante est effectuée sous forme d'une impulsion de courant par au moins une chaîne de traitement de l'information comprenant un dispositif de remise en forme, de manière à conditionner les signaux délivrés par la matrice de détecteurs. Les signaux issus de la (ou des) chaîne(s) de traitement sont multiplexés vers des moyens générant au moins une sortie numérique. Le dispositif de remise en forme est extérieur au point élémentaire dans le cas d'une matrice de détecteurs. Dans celui d'une barrette de détecteurs, le dispositif de remise en forme est situé soit à l'extérieur, soit à l'intérieur du point élémentaire.

Avantageusement les détecteurs photoniques sont des détecteurs quantiques, ou des détecteurs thermiques. Ils sont réalisés sur un autre substrat que ledit dispositif de lecture, ou directement sur le circuit du dispositif de lecture.

L'invention concerne un circuit de lecture d'un signal délivré par au moins un détecteur, par exemple ayant une grande cadence de lecture, le temps de pose étant identique et synchrone pour tous les détecteurs, caractérisé en ce qu'il comprend un ensemble de points élémentaires répartis en lignes et en colonnes de manière à décrire une matrice.

Avantageusement chaque point élémentaire est constitué :

- d'un dispositif d'adaptation d'impédance, muni d'une première horloge, apte à polariser le détecteur et à lire le courant fourni par le détecteur;
- au moins d'un transistor MOS, muni d'une seconde horloge apte d'une part à intégrer le courant fourni par le détecteur, d'autre part à stocker la charge obtenue, et enfin associé à un dispositif d'adressage, à évacuer cette charge, sous forme d'une impulsion de courant, sur un dispositif de remise en forme du courant qui transforme cette impulsion de courant en un signal de type binaire, ce dispositif de remise en forme étant extérieur au point élémentaire ;
- le dispositif d'adressage, muni d'une troisième horloge, apte à commuter la source et/ou le drain du transistor MOS sur une connexion commune des points élémentaires d'une même colonne, appelée bus-colonne.

Chaque bus colonne est relié à une chaîne de traitement comprenant les moyens suivants :

- ledit dispositif de remise en forme du signal apte à lire et à convertir l'impulsion de courant issus d'un point élémentaire, en un signal de type binaire, pendant un signal de la seconde horloge, de façon simultanée et ceci pour chaque point d'une même ligne, les lignes étant traitées les unes après les autres ;
- un compteur muni d'une quatrième horloge qui compte les coups d'horloge pendant toute la durée du signal issu du dispositif de remise en forme ;
- un dispositif de lecture du signal numérisé.

Le dispositif d'adaptation d'impédance est relié par son entrée au détecteur, par sa sortie à la source et/ou au drain du transistor MOS et par sa commande à la première horloge qui commute entre une tension de blocage et une tension de polarisation.

La grille du transistor MOS est reliée à la seconde horloge qui, commutée à une certaine tension permet l'évacuation de la charge stockée sur une connexion commune et, commutée à une autre tension, intègre le courant issu du détecteur et stocke la charge obtenue.

Le dispositif d'adressage est relié, par son entrée à la source et/ou au drain du transistor MOS, par sa sortie au bus colonne et par sa commande à une troisième horloge qui commute entre une tension de blocage et une tension pour laquelle le dispositif d'adressage est passant. Dans le cas particulier où le dispositif d'adressage est un transistor, il est apte à générer une barrière de potentiel entre le potentiel de son canal et celui du transistor MOS.

Le dispositif de remise en forme du courant est connecté en entrée au bus colonne et en sortie, au compteur.

Le compteur est connecté en sortie au dispositif de lecture de signal numérisé.

Avantageusement un dispositif de stockage des données est connecté entre le compteur et le dispositif de lecture de signal numérisé.

Le dispositif de stockage peut être une mémoire vive (RAM en anglais).

La mémoire en sortie du compteur peut être une bascule de type D.

Le dispositif de remise en forme du signal analogique peut être un amplificateur courant/tension.

L'invention a pour but de simplifier l'électronique d'un circuit de lecture en supprimant des points élémentaires, les dispositifs de remise à zéro présents dans le pixel même des dispositifs de l'art antérieur. Cette fonction est néanmoins conservée mais elle est effectuée par le dispositif de remise en forme, extérieur au point élémentaire. L'invention a aussi pour but de fournir une information de type numérique obtenue d'une façon très simple.

Dans le cas d'une barrette de détecteurs, il n'y a pas de connexion commune. Il y a autant de dispositifs de remise en forme du courant (par exemple des amplificateurs de courant-tension) que de lignes dans la barrette. Le multiplexage est limité au multiplexage des sorties des compteurs.

Le dispositif de l'invention permet d'obtenir une information numérique utilisable directement par les procédés de traitement d'images.

L'invention permet de convertir l'information analogique du détecteur obtenue à la sortie d'un transistor MOS, en information numérique. Pour cela, on ajoute un compteur qui se déclenche dès que l'impulsion de courant est présente sur le bus-colonne et s'arrête quant l'impulsion est finie.

Avantageusement le dispositif d'adaptation d'impédance est un transistor MOS. Le dispositif d'adressage est un transistor MOS utilisé en interrupteur, le niveau analogique appliqué sur sa grille pour le rendre passant est tel que la valeur absolue de la différence de potentiel grille-source est légèrement supérieure à la valeur absolue de la tension de seuil du transistor MOS.

Avantageusement le temps d'établissement du signal de sortie du dispositif de remise en forme est inférieur au temps de descente de l'horloge qui pilote la grille du transistor. Dans le cas d'une barrette de détecteurs soit il y a connexion commune et un seul dispositif de remise en forme, soit il n'y a pas de connexion commune et autant de dispositifs de remise en forme et de compteurs que de lignes dans la barrette, le multiplexage étant limité au multiplexage des signaux issus des compteurs.

Avantageusement la tension qui permet de stocker les charges est la masse pour un transistor PMOS et est égale à la tension d'alimentation pour un transistor NMOS.

Les propriétés fondamentales des points élémentaires de cette architecture sont les suivantes :

- avoir un temps de pose de même durée et synchrone pour tous les points élémentaires ;
- préintégrer sous forme d'un paquet de charges $Q_{ij}$ le courant $id_{ij}$ délivré par le détecteur $D_{ij}$ pendant le temps de pose $T_{pose}$

$$Q_{ij} = T_{pose} \times id_{ij}$$

- convertir, en sortie du point élémentaire, la quantité de charges intégrées, en une impulsion de courant d'amplitude ajustable et constante $I_{pulse}$ pour tous les points élémentaires d'une mosaïque, et de durée $\delta t_{ij}$ proportionnelle à la quantité de charges stockées

$$Q_{ij} = I_{pulse} \times \delta t_{ij} = T_{pose} \times Id_{ij}$$

donc:

$$\delta t_{ij} = (T_{pose}/I_{pulse}) \times Id_{ij}$$

En résumé, cette architecture délivre en sortie de ces points élémentaires une impulsion de courant d'amplitude constante pour tous les points élémentaires et de durée proportionnelle au courant moyen de chaque détecteur de la mosaïque intégré pendant un temps de pose synchrone et identique pour tous ces détecteurs.

La présente invention concerne également un procédé de lecture d'une matrice de détecteurs photoniques, qui délivre un courant dont l'intensité varie en fonction du flux incident, caractérisé en ce qu'il comprend les étapes suivantes :

- conversion du courant du détecteur en charge par intégration d'une durée égale au temps de pose ;
- conversion de la charge intégrée en une impulsion de courant dont l'amplitude est ajustable en fonction d'un stimulus et dont la durée varie en fonction de la charge stockée ;
- numérisation de cette impulsion de courant en tension au moyen en particulier d'un compteur.

Avantageusement il comporte les étapes suivantes :

- La première horloge Hp étant au niveau de la tension de polarisation Vpol, la seconde HCi (i est le numéro des lignes) étant au niveau permettant le stockage des charges et la troisième à la tension de blocage: une fois par image, il y a intégration du courant fourni par le détecteur dans le transistor MOS (stockage) pendant un temps prédéfini en fonction des conditions d'éclairement de la scène, des caractéristiques du détecteur, de la valeur de la capacité de stockage.
- La première horloge Hp revenant à sa tension de blocage ; la seconde horloge HCi variant de façon linéaire depuis le niveau permettant le stockage des charges jusqu'au niveau bloquant le transistor (le taux de variation étant déterminé par rapport aux caractéristiques du dispositif de remise en forme) ; et, la troisième horloge HAi commutant au niveau Vécran : étape d'évacuation des charges réalisée pour chaque ligne de la matrice lors de la lecture et de la numérisation du signal; la seconde horloge HCi étant à la tension de blocage ; la troisième horloge HAi commutant à la tension de blocage et on recommence pour la ligne suivante.
- Lorsque l'on a balayé toutes les lignes, on recommence les étapes précédentes pour une autre image.

Dans l'invention on numérise la largeur de l'impulsion de courant pour convertir ce signal analogique en numérique par une technique couramment employée dans d'autres capteurs. Pour ce faire, on modifie la chaîne de traitement du signal à partir de l'amplificateur de charges qui est remplacé par un compteur binaire.

Ainsi on réalise dans le plan focal, de manière simple, la conversion analogique-numérique des informations contenues dans une image d'une mosaïque à prise de vue synchrone.

Brève description des dessins

- Les figures 1A et 1B illustrent une architecture de circuit de lecture de l'art antérieur de type à transfert de charges ;
- les figures 2A et 2B illustrent une architecture de circuit de lecture de l'art antérieur de type suiveur commuté ;
- les figures 3A et 3B illustrent une architecture de circuit de lecture de l'art antérieur de type partition bus colonne ;
- les figures 4A et 4B illustrent une architecture de circuit de lecture de l'art antérieur de type intégration déportée ;
- les figures 5A et 5B illustrent une architecture de circuit de lecture selon l'invention ;
- la figure 6 illustre un exemple de réalisation du dispositif de l'invention ;
- la figure 7 illustre les variations au cours d'un cycle complet de fonctionnement des profils de potentiel dans un point élémentaire selon l'invention ;
- la figure 8 illustre un chronogramme de lecture de deux points élémentaires selon l'invention ;
- la figure 9A, 9B et 10A, 10B illustrent l'implantation et le schéma électrique d'une mosaïque de deux lignes par deux colonnes de points élémentaires, respectivement pour un circuit de lecture de l'art antérieur de type suiveur commuté et pour un circuit de lecture selon l'invention ;
- la figure 11 illustre le schéma de principe de calibration électrique selon l'invention .

Exposé détaillé de modes de réalisations

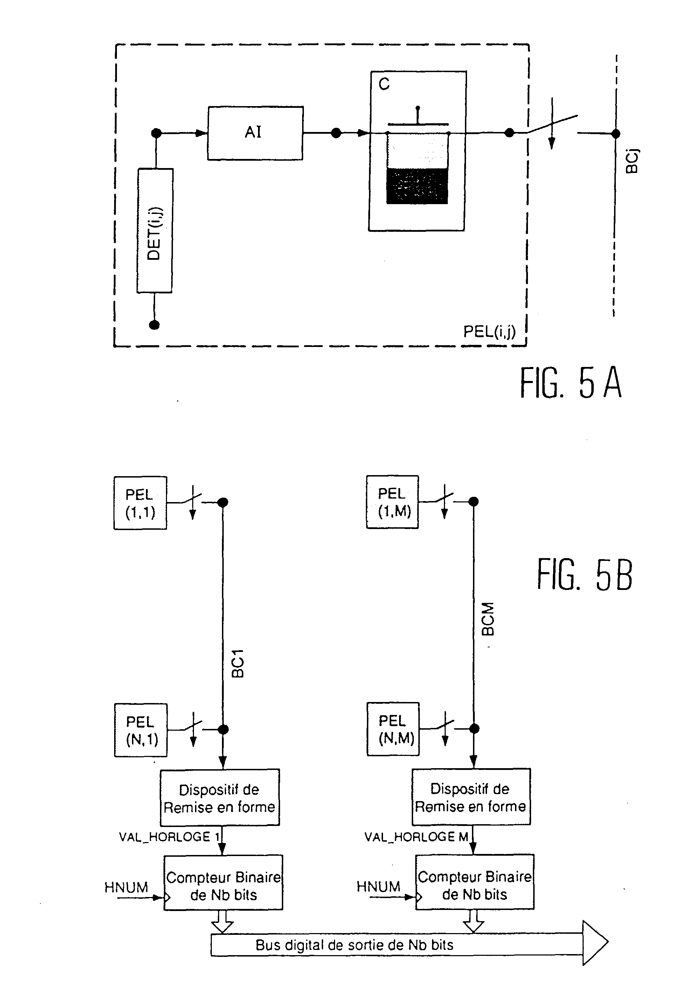

L'architecture du circuit selon l'invention est représenté sur les figures 5A et 5B dans le cas d'une matrice de N lignes par M colonnes, la figure 5A représentant le détail d'un point élémentaire.

Le circuit de lecture se présente exactement sous la même forme qu'un circuit de lecture de type SCA analogique pour tout ce qui est de l'architecture des points élémentaires, leur connexion sur les différents bus colonne et des chronogrammes des horloges de commande des dispositifs formant l'ensemble des points élémentaires, tout ceci étant dans un souci de disposer la caractéristique fondamentale des impulsions de courant issus des points élémentaires sur les bus colonnes.

On trouve dans chaque point élémentaire :

- un dispositif d'adaptation d'impédance entre le détecteur et le condensateur de stockage (si nécessaire) ;
- un condensateur de stockage réalisé au moyen d'un transistor MOS dont la source et/ou le drain sont connectés au détecteur via un interrupteur et dont la grille est pilotée par une horloge ;
- un dispositif d'adressage, symbolisé, dans un souci de simplification, par un interrupteur, qui permet de commuter la source et/ou le drain du transistor MOS de stockage sur une connexion commune aux points élémentaires d'une même colonne, dite bus colonne.

Pour chaque colonne, les modifications de l'architecture n'apparaissent qu'à l'extrémité du bus colonne où l'amplificateur de charges cède sa place à un dispositif de remise en forme des impulsions de courant. Celui-ci délivre un signal VAL_HORLOGEj de durée identique à l'impulsion de courant issue du point élémentaire et d'amplitude compatible avec les signaux de commande du compteur binaire. Le signal VAL_HORLOGEj sert à valider l'horloge HNUM du compteur, pendant la durée de l'impulsion de courant. Le compteur réalise ainsi la conversion analogique-numérique du courant moyen du détecteur intégré pendant $T_{pose}$ en comptant le nombre de périodes d'horloge HNUM pendant la durée du signal VAL_HORLOGEj.

Les mots binaires stockés dans les compteurs colonnes sont donc, à la fin de la lecture d'une ligne, proportionnels à la durée des impulsions remises en forme (VAL_HORLOGEj). Autrement dit, en supposant la chaîne analogique idéale, le contenu binaire des compteurs colonnes est proportionnel à la charge stockée dans les points élémentaires de la ligne lue. Il suffit alors de venir lire le contenu des M compteurs colonnes au moyen d'un bus logique à Nb bits avant de réinitialiser les compteurs afin de procéder à la lecture des lignes suivantes.

**Prise d'image synchrone**

A chaque trame, les interrupteurs des dispositifs d'adaptation d'impédance de tous les points élémentaires sont fermés de manière synchrone, les interrupteurs des dispositifs d'adressage de chaque point élémentaire étant ouverts.

Pour chaque point élémentaire, le courant délivré le détecteur est alors intégré dans le canal d'inversion du transistor MOS pendant une durée $T_{pose}$.

A la fin du temps de pose, les interrupteurs des dispositifs d'adaptation d'impédance de tous les points élémentaires sont ouverts de manière synchrone. On a donc le même temps de pose pour chacun des détecteurs.

**Lecture séquentielle ligne par ligne de la matrice**

Les lignes de détecteurs sont alors sélectionnées les unes après les autres. A chaque temps ligne, les interrupteurs des dispositifs d'adressage d'une même ligne sont fermés. Les grilles des transistors MOS de stockage d'une même ligne sont alors pulsées de façon à provoquer l'injection des charges stockées dans leur canal sur leur bus colonne respectif et, par voie de conséquence, la remise à zéro de charge stockée dans le canal d'inversion des transistors MOS de stockage.

Le bus colonne est supposé maintenu à un potentiel constant par le dispositif de remise en forme dont l'impédance d'entrée est par ailleurs supposée infinie. L'impulsion de courant ainsi provoquée par l'injection de charges est convertie en un signal de même durée, compatible avec ceux de commande du compteur par le dispositif de remise en forme. La sortie du compteur qui a assuré la conversion analogique-numérique, peut alors être multiplexée vers le bus numérique de sortie pour être traitée.

Il est alors possible de réinitialiser le compteur, d'ouvrir l'interrupteur du dispositif d'adressage colonne et enfin de créer un nouveau puits de potentiel, vide de toute charge, sous la grille du transistor MOS de stockage avant de procéder à la lecture de la ligne suivante.

L'expression de la durée de l'impulsion de courant ou du signal issu du dispositif de remise en forme $\delta T_{ij}$ connecté à la colonne j en fonction du courant $id_{ij}$ délivré par le détecteur du point élémentaire PEL(i,j) est donnée par l'expression :

$$\delta T_{ij} \times I_{pulse} = Id_{ij} \times T_{pose}$$

où $I_{pulse}$ est l'amplitude constante des impulsions de courant sur les bus colonne.

Il faut noter que l'amplitude $I_{pulse}$ des impulsions de courant sur les bus colonne est optimisable en ajustant le taux de variation du front de descente de l'horloge HCi. En effet, la rampe de tension ainsi appliquée à la grille va avoir pour effet, dans une première approximation, de provoquer une injection de charge dans le bus colonne, par dessus la barrière de potentiel générée par un transistor Ta, à un taux constant. On obtient ainsi une impulsion de courant dont l'amplitude est proportionnelle à la capacité d'intégration et au taux de variation du front de descente de HCi. Ce taux de variation du front de descente de l'horloge HCi(t) doit être constant dans le temps et pour toutes les lignes.

On a $\delta T_{ij}$ < durée du front de descente de l'horloge HCi.

La valeur numérique obtenue en sortie du compteur est donnée par la relation suivante ;

$$N_{NUM} = \delta T_{ij} \times F_{HNUM} = Id_{ij} \times T_{pose} \times F_{HNUM} / I_{pulse}$$

où $F_{HNUM}$ est la fréquence de l'horloge HNUM du compteur.

**Nombre de bits du compteur**

Le nombre de bits (Nb) du compteur colonne doit être tel que la dynamique de codage soit compatible avec le rapport signal sur bruit de la charge à lire, noté ci-après $(S/B)_q$.

En première approximation, on suppose que ce rapport signal sur bruit est donné par la relation suivante :

$$(S/B)_q = (Id \times TP/q)^{1/2}$$

où Id est le courant délivré par le détecteur, Tp le temps de pose et q la charge de l'électron.

Un premier ordre de grandeur de Nb est obtenu en écrivant que le nombre d'états du compteur est égal à la dynamique en charge du point élémentaire :

$$2^{Nb} = (S/B)_q$$

ce qui donne finalement :

$$Nb = [20 \log_{10}(S/B)_q]/6$$

Le tableau suivant donne la relation entre la dynamique en charge et le nombre de bits du compteur:

| Nb | (S/B)q en dB |
|----|--------------|
| 8  | 48 |
| 9  | 54 |
| 10 | 60 |
| 11 | 66 |
| 12 | 72 |
| 13 | 78 |
| 14 | 84 |
| 15 | 90 |
| 16 | 96 |

**Fréquence du compteur**

C'est l'autre paramètre dimensionnant du système car il détermine le pas de quantification temporel de la durée des impulsions. La fréquence de l'horloge du compteur ($F_{HNUM}$) est obtenue en écrivant que la durée maximale de l'impulsion de courant ($\delta T_{ij}^{max}$) est codée pleine échelle sur le compteur :

$$\delta T_{ij}^{\ max} = 2^{Nb} / F_{HNUM}$$

d'où :

$$F_{HNUM} = 2^{Nb} / \delta T_{ij}^{\ max}$$

Cette relation montre clairement qu'il faut optimiser les réglages des horloges HCi de façon à augmenter $\delta T_{ij}^{max}$ si l'on veut minimiser $F_{HNUM}$.

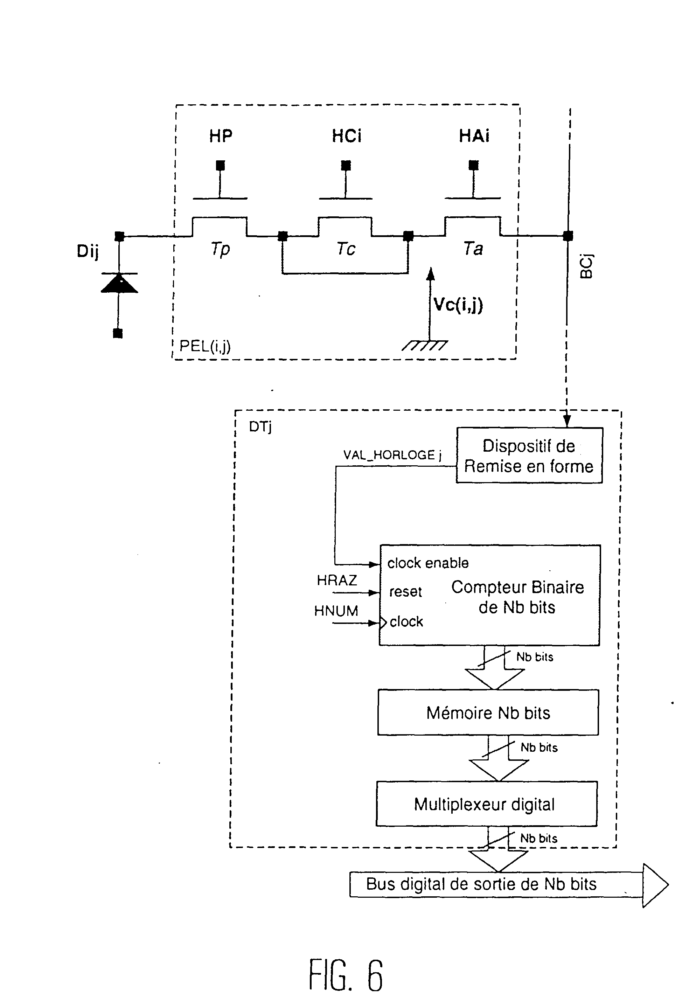

Le schéma de principe d'un exemple de réalisation d'un circuit de lecture selon l'invention est donné sur la figure 6.

Ce circuit est supposé lire une matrice N lignes par M colonnes de détecteurs. Le point élémentaire de la ligne i et de la colonne j PEL(i,j) y est représenté. Sa sortie attaque le bus colonne BCj qui est connecté au dispositif de remise en forme placé en entrée du dispositif de traitement du signal DTj propre à cette colonne. Le signal de sortie du dispositif de remise en forme (VAL_HORLOGEj) est compatible avec les signaux de commande d'un compteur binaire de Nb bits et il est connecté sur la commande de validation (ENABLE) de l'horloge de ce compteur (HNUM). Le compteur assure la conversion analogique-numérique de l'information. Sur la sortie du compteur, la valeur numérique de la quantité de charges issue du point élémentaire traité est donc disponible, il ne reste plus qu'à gérer celle-ci vers le bus digital de sortie par l'intermédiaire d'une mémoire (optionnelle) et d'un multiplexeur.

Le fonctionnement de ce dispositif de l'invention est le suivant :

- Pour la prise d'image : une première horloge HP (commune à tous les dispositifs d'adaptation d'impédance de tous les points élémentaires) est au niveau de la tension de polarisation Vpol, les horloges HCi propres à chaque ligne (i étant le numéro de la ligne) sont au niveau de tension permettant le stockage des charges et les horloges HAi propres à chaque ligne à la tension de blocage : une fois par image, il y a intégration du courant fourni par le détecteur dans le transistor MOS (stockage) pendant un temps prédéfini en fonction des conditions d'éclairement de la scène, des caractéristiques du détecteur, de la valeur de la capacité de stockage. Ceci se passe pour tous les détecteurs simultanément (lecture synchrone) parce que toutes les horloges HCi et HAi associées à chaque ligne i sont au niveau de la tension permettant le stockage des charges pour l'horloge HCi et à la tension de blocage pour l'horloge HAi.

- La première horloge HP revient au niveau de la tension de blocage. Pour chaque ligne i, la seconde horloge HCi varie de sa tension stockage des charges à une tension de blocage du transistor de façon linéaire (la croissance ou la décroissance étant déterminées par rapport aux caractéristiques du dispositif de remise en forme du courant), et la troisième horloge HAi commute à un niveau Vécran pendant cette variation de la seconde horloge HCi. Pour chaque point élémentaire d'une même ligne, il y a une étape d'évacuation des charges stockées pour chaque ligne de la matrice et simultanément, une conversion analogique-numérique des charges stockées pour chaque ligne de la matrice.

- Le principe de la conversion analogique-numérique est le suivant: la durée du signal de sortie du dispositif de remise en forme de la colonne j est égale à la durée de l'impulsion de courant délivrée sur le bus colonne BCj par point élémentaire PEL(i,j) pendant la variation de la seconde horloge HCi de sa tension stockage des charges à sa tension de blocage du transistor, elle-même proportionnelle à la quantité de charge stockées sous le transistor MOS du point élémentaire PEL(i,j). Le compteur logique j, réinitialisé au préalable par l'horloge HRAZ, compte le nombre de périodes d'horloge HNUM pendant la durée du signal issu du dispositif de remise en forme.

Lorsque l'on a balayé toutes les lignes, on recommence les différentes étapes précédentes pour une autre image.

La tension Vécran est la tension pour laquelle le transistor est passant mais apte à générer une barrière de potentiel entre le potentiel de son canal et celui du transistor MOS.

La tension de blocage est la tension appliquée sur la commande de façon à ce qu'aucun courant ne circule entre l'entrée et la sortie du dispositif.

Le dispositif de l'invention, tel que précédemment décrit et tel que représenté sur les figures 5A, 5B, et 6 pour un exemple de réalisation, permet d'obtenir une information numérique utilisable directement par les procédés de traitement d'images.

L'invention permet de convertir l'information analogique du détecteur, obtenue à la sortie du transistor MOS en information numérique. Pour cela, on ajoute un compteur qui se déclenche dès que l'impulsion de courant est présente sur le bus-colonne et s'arrête quant l'impulsion est finie.

Chaque détecteur DET (i,j) est supposé être un détecteur photovoltaïque de type N sur substrat P. Il est schématisé par une diode Dij.

L'adaptation d'impédance entre le détecteur DET(i,j) et le point élémentaire PEL(i,j) est réalisé par un transistor NMOS Tp, ici monté en grille commune qui présente une faible impédance d'entrée et une très forte impédance de sortie. Sa source est connectée au détecteur et son drain à la source du transistor NMOS d'intégration Tc.

Ce principe de couplage des détecteurs photovoltaïques à leurs circuits de lecture est très classique et est souvent désigné par injection directe dans la littérature. Il en existe de nombreuses variantes destinées principalement à diminuer l'impédance d'entrée et/ou à augmenter l'impédance de sortie.

Une horloge, désignée par HP, est appliquée à la grille de tous les transistors Tp de la mosaïque.

Le condensateur d'intégration C est ici réalisé au moyen d'un transistor NMOS Tc dont la source et le drain peuvent être court-circuitées comme c'est le cas sur la figure 6.

Les diodes de source et de drain du transistor Tc sont reliées d'une part au drain du transistor Tp, et d'autre part à la diode d'entrée du transistor NMOS d'adressage Ta.

L'horloge HCi est appliquée à la grille du transistor Tc. L'indice i précise que tous les transistors Tc d'une même ligne sont attaqués par cette horloge, et que chaque ligne du circuit de lecture est attaquée par une horloge différente.

Le transistor NMOS d'adressage Ta est monté en interrupteur entre la source et/ou le drain du transistor Tc et la connexion bus colonne BCj.

L'horloge HAi est connectée à sa grille. L'indice i précise que cette horloge attaque tous les transistors Ta de la ligne, et que chaque ligne du circuit de lecture est attaquée par une horloge différente.

Le bus colonne BCj est connecté à l'entrée d'un dispositif de remise en forme qui assure la conversion de l'impulsion de courant issu du point élémentaire PEL(i,j) en un signal compatible avec les signaux logiques utilisés dans le compteur binaire tout en respectant la durée de l'impulsion de courant. Ce dispositif assure aussi la polarisation du bus colonne afin que celle-ci soit maintenue constante pendant toute la durée des impulsions de courant associées à ce bus.

Avantageusement ce dispositif de remise en forme peut être réalisé avec un amplificateur courant-tension dont le gain est suffisamment important pour saturer l'amplitude du signal de sortie aux tensions d'alimentation de l'amplificateur, les tensions d'alimentation étant compatibles avec les niveaux logiques des signaux de pilotage du compteur.

Le compteur binaire est un compteur binaire de Nb bits qui assure la conversion analogique-numérique de l'information. Il dispose au minimum des signaux de commande suivants :

- une horloge de comptage (HNUM) ;
- une entrée de réinitialisation ou de prépositionnement des Nb étages le constituant (HRAZ) ;
- une entrée de validation de l'horloge de comptage (VAL_HORLOGEj).

Le dispositif de mémorisation permet de mémoriser un mot binaire de Nb bits à partir d'un signal de commande.

Ce dispositif est optionnel mais il permet de pouvoir simultanément multiplexer vers le bus numérique de sortie de Nb bits les M mots binaires représentatifs d'une ligne précédemment traitée et de numériser les M nouvelles informations de la nouvelle ligne traitée.

Le multiplexeur logique assure le multiplexage des M mots binaires représentatifs d'une ligne vers le bus digital de sortie.

Avant de décrire le fonctionnement électrique d'un point élémentaire, il est indispensable d'exposer les principes qui gouvernent le dimensionnement de ce type de circuit et le réglage des différents stimulis.

Les horloges utilisées pour piloter ce circuit sont supposées commutées entre deux niveaux analogiques qui ne sont pas toujours égales aux tensions d'alimentations (Vdd, Vss) des circuits comme c'est souvent l'usage par convention dans la suite, la tension de sortie des horloges :

- à l'état haut est notée H(1) ;
- à l'état bas est notée H(0).

Le transistor de polarisation a deux fonctions :

- polariser le détecteur;
- contrôler le temps de pose.

La première fonction est obtenue en appliquant à la grille du transistor NMOS une tension Vpol telle qu'il soit polarisé en régime de saturation, c'est-à-dire dans une zone où il présente une résistance dynamique drain-source élevée. Pour ce faire, dans le cas qui nous intéresse, il suffit d'appliquer à la grille du transistor Tp une tension sensiblement égale à la tension de seuil Vtn de ce transistor MOS.

La deuxième fonction est obtenue en appliquant à la grille du transistor Tp une tension telle que ce transistor Tp soit bloqué. Pour ce faire, dans le cas qui nous intéresse, il suffit d'appliquer à la grille du transistor Tp une tension Vtb qui garantit que celui-ci ne laisse passer aucun courant, même en régime de faible inversion. Pratiquement, il suffit d'appliquer la tension minimum autorisée par la filière, désignée ici par Vss, pour avoir une marge de bruit suffisante.

Le transistor de polarisation remplit donc ses fonctions si l'horloge Hp commute entre les niveaux suivants :

- HP(1) $\approx$ Vtn ;
- HP(0) = Vtb $\approx$ Vss.

Le transistor MOS d'intégration Tc doit être piloté par une horloge Hc de façon à ce qu'il remplisse les trois fonctions suivantes ;

- maximiser la charge stockable ;
- réinitialiser sa capacité entre deux images ;
- contrôler à chaque lecture le courant qui sera injecté dans le dispositif de remise en forme.

Dans la plupart des applications, il est souhaitable de maximiser le rapport signal sur bruit dès le premier étage du circuit de lecture, ce qui revient en général à maximiser la charge stockable dans le canal d'inversion du transistor Tc.

Pour ce faire, il suffit d'appliquer à la grille du transistor Tc la tension maximum autorisée par la filière que l'on désigne ici par Vdd. La charge stockable maximum Qsm dans le point élémentaire peut alors être approximée par la formule suivante, en négligeant la capacité des diodes de source et drain des transistors Tp, Tc et Ta, et autres capacités parasites connectées à ce même noeud électrique :

$$Qsm = Cox \times S \times (Vdd - Vtn)$$

où:

Cox est la capacité par unité de surface de la grille de Tc;
S est la surface active de la grille de Tc ;
Vtn est la tension de seuil du transistor NMOS Vtn.

La réinitialisation du condensateur d'intégration est parfaite si la tension appliquées à la grille du transistor Tc fait passer le canal en régime d'accumulation. Autrement dit il n'est plus possible d'y stocker des électrons. Pour ce faire il faut que cette tension soit inférieure à la tension de seuil du transistor Tc. Il est souvent commode tout comme pour le transistor Tp, d'utiliser l'alimentation Vss.

En résumé, l'horloge HCi doit, pour satisfaire les deux premières contraintes, être commutée entre les niveaux :

- HCi(1) = Vdd ;
- HCi(0) = Vss.

Le dispositif de remise en forme doit satisfaire les contraintes suivantes :

- délivrer un signal de sortie compatible en grandeur (généralement des tensions) et en amplitude avec les signaux logiques de commande du compteur binaire ;
- maintenir le bus colonne à un potentiel constant pendant la lecture des charges stockées dans un point élémentaire ;
- consommer le moins possible afin de minimiser la consommation dans les circuits de lecture de composants de grand format.

Dans le cas de l'invention, il remet en forme l'impulsion de courant Ibusj en un signal VAL_HORLOGEj compatible avec les signaux de commande du compteur.

On peut montrer que le deuxième point est satisfait en utilisant un dispositif dont le produit gain x bande est adapté au temps de montée de l'impulsion de courant qui est injectée dans le bus.

Si tel n'était pas le cas, la durée de l'impulsion de courant aurait de grande chance de ne plus être conservée sur le signal VAL_HORLOGEj, ceci entraînant dans le compteur une distorsion lors de la conversion analogique-numérique.

Le transistor d'adressage doit remplir trois fonctions :

- garantir l'isolement électrique entre le canal du transistor Tc et le bus colonne afin qu'aucune charge ne puisse être échangée entre le bus colonne et le condensateur d'intégration du point élémentaire considéré en dehors de la lecture de ce point élémentaire ;
- ne pas retenir une partie de la charge injectée sur le bus colonne ;
- minimiser le temps de montée de l'impulsion de courant induite par ce transfert de charges.

La première contrainte est satisfaite en appliquant sur la grille du transistor Ta une tension inférieure à sa tension de seuil, ce qui a pour effet de bloquer ce transistor. Pour ce faire, il est commode, tout comme pour le transistor de polarisation d'utiliser l'alimentation Vss comme niveau bas.

La deuxième contrainte est obtenue en appliquant sur la grille du transistor Ta une tension Vécran telle que le potentiel de canal à vide du transistor Tc soit légèrement inférieur à une tension Vbus. La marche de potentiel ainsi créée entre le canal du transistor Tc et le bus colonne assure le transfert de tous les électrons stockés dans le canal du transistor Ta. Une estimation grossière de la tension à appliquer consiste à écrire que le transistor Ta doit être passant, autrement dit que sa tension grille doit être égale à sa tension source, égale à Vbus, plus sa tension de seuil, en tenant compte de l'effet substrat.

C'est la troisième contrainte qui met en évidence le fait que le transistor Ta ne doit pas être considéré comme interrupteur classique, autrement dit que le niveau haut de HAi ne doit pas être Vdd. En effet, si tel était le cas, c'est une impulsion de charges de très courte durée qui serait envoyée sur le bus lorsque le transistor Ta passerait de l'état de circuit ouvert à l'état de circuit fermé. L'impulsion de courant induite sur le bus serait alors de forte amplitude et de très faible durée, ce qui imposerait des contraintes rédhibitoires sur certaines des caractéristiques électriques du dispositif de remise en forme ainsi que sur la cadence de l'horloge HNUM. Pour éviter ce phénomène, il suffit que le potentiel de canal sous le transistor Ta joue le rôle d'une barrière de potentiel vis-à-vis des charges stockées sous le transistor Tc. Pour ce faire, il faut et il suffit que la tension appliquée à la grille du transistor Ta à l'état haut satisfasse exactement la contrainte précédente.

Pratiquement, les niveaux des horloges HAi sont:

- HAi(0) = Vss ;
- HAi(1) $\approx$ Vbus + Vtn(Vbus).

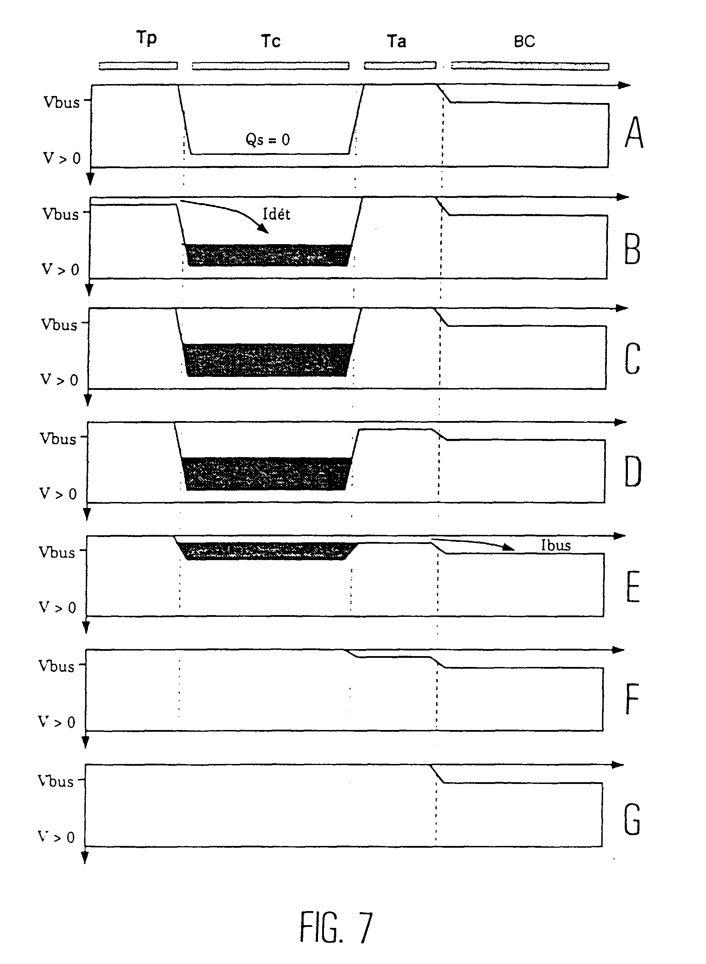

Les variations au cours d'un cycle complet de fonctionnement des profils de potentiels dans les différents transistors MOS du point élémentaire sont schématisées sur la figure 7. Le cycle de fonctionnement y a été découpé en sept phases :

- Phase A : cette phase précède le temps de pose. Tp est bloqué. Le puits de potentiel sous Tc existe, mais il est vide (Qs = 0). Ta est bloqué.
- Phase B : le point élémentaire est en cours d'intégration. Tp est passant. Le courant débité par le détecteur (Idét) est intégré dans le puits de potentiel sous Tc.
- Phase C: c'est la fin du temps de pose. Tp est bloqué, ce qui a pour effet d'échantillonner-bloquer le potentiel sous Tc.
- Phase D: c'est le début de la lecture du point élémentaire. Seule la tension appliquée à la grille de Ta est modifiée de façon à le rendre passant et à créer une barrière de potentiel entre Tc et le bus colonne.
- Phase E : les charges stockées sous Tc sont injectées par dessus la barrière de potentiel créée sous Ta dans le puits de potentiel du bus colonne.
- Phase F: toutes les charges stockées sous Tc ont été injectées dans le bus colonne. Le puits de potentiel sous Tc est vide.
- Phase G: c'est la fin de la lecture du point élémentaire. Ta est bloqué de façon à procéder à la lecture d'un autre point élémentaire ou bien à prendre une autre image.

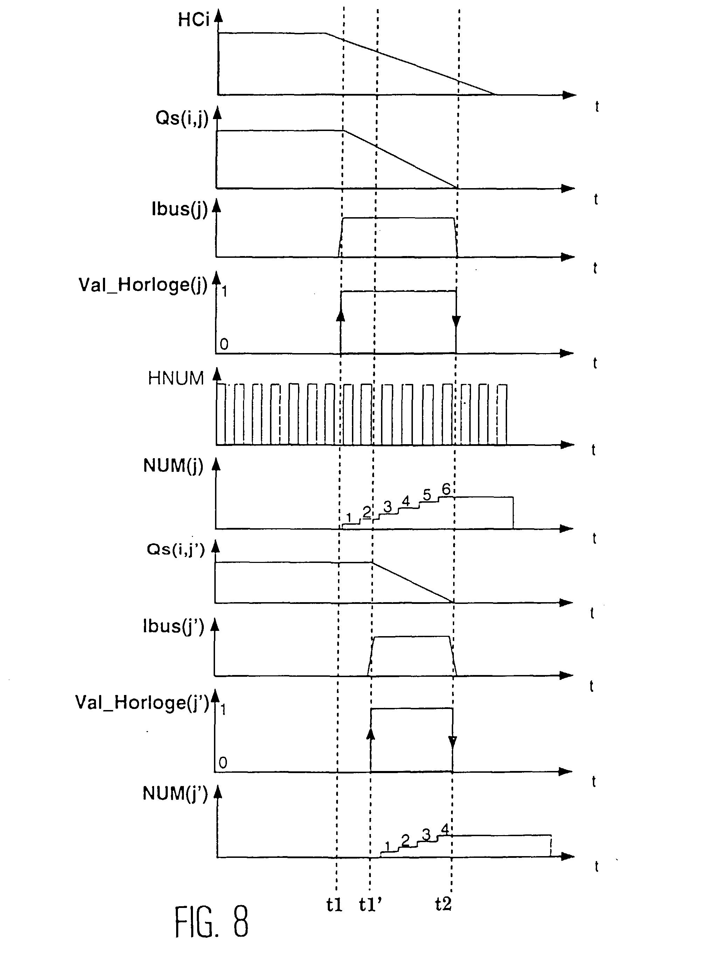

Enfin, les courbes de la figure 8 permettent de mieux comprendre comment certaines grandeurs électriques varient en fonction de la charge stockée dans le point élémentaire. Pour ce faire, on désigne par Qs(i,j) et Qs(i,j') la charge stockée dans deux points élémentaires de la même ligne i, mais de deux colonnes différentes, notées ici j et

EP 0 749 233 B1

j', à la fin d'un temps de pose. La tension appliquée à la grille des transistors MOS de stockage Tc de ces deux points élémentaires est désignée par l'horloge HCi. On suppose que le taux de variation de son front de descente est constant. Les courants injectés dans les bus des colonnes j et j' sont notés respectivement Ibus(j) et Ibus(j'). Les tensions de sortie des dispositifs de remise en forme connectés aux bus colonnes j et j' sont notées respectivement VAL_HORLOGE (j) et VAL_HORLOGE(j').

Ces courbes mettent en évidence que le courant injecté dans le bus colonne j (respectivement j') devient non nul à partir d'un instant t1 (respectivement t1'). Ces courbes montrent clairement que cet instant varie proportionnellement avec la charge stockée car moins cette charge est importante, plus il faut que le potentiel de canal sous le transistor Tc diminue, sous l'effet de la diminution de la tension HCi, pour que les charges stockées sous le transistor Tc puissent franchir la barrière de potentiel sous le transistor Ta.

La lecture s'achève en fait, au même instant t2 pour les deux points élémentaires lorsque les dernières charges stockées dans les deux points élémentaires sont injectées dans leurs bus respectifs. Les courants Ibus(j) et Ibus(j') devenant nul à partir de l'instant t2.

Les signaux de sortie des dispositifs de remise en forme valident l'horloge de comptage HNUM pour leur compteur respectif qui comptent donc pendant la durée de ces impulsions, les compteurs étant préalablement réinitialisés avant le début du comptage.

Les dispositifs de remise en forme ne modifient que l'amplitude et la grandeur des impulsions de courant, la durée des impulsions étant conservée.

A la fin de ces impulsions (après l'instant t2), les compteurs disposent, sur leurs Nb bits de sortie, des nombres de coups d'horloge comptés pendant la durée de ces impulsions, ces nombres n'étant autres que les images numériques des durées de ces impulsions.

Il ne reste plus qu'à lire de manière séquentielle les mots binaires présents en sortie des M compteurs avant de réinitialiser ceux-ci en vue de la lecture de la ligne suivante.

En résumé, on peut considérer que l'invention conditionne le courant délivré par les détecteurs quantiques et les détecteurs thermiques de la manière suivante :

- conversion du courant du détecteur en charge par intégration d'une durée égale au temps de pose ;
- conversion de la charge intégrée en une impulsion de courant dont:

  • l'amplitude est constante pour tous les détecteurs et ajustable en fonction d'un stimulus,
  • la durée varie proportionnellement en fonction de la charge stockée ;

- conversion de la largeur de cette impulsion de courant en une valeur numérique au moyen d'un compteur binaire.

Avantages particuliers

**Prise de vues**

La solution proposée permet d'avoir un temps de pose de même durée et synchrone pour tous les points élémentaires, ce qui n'est pas le cas des solutions à intégration déportée.

**Rendement technologique, densité d'intégration, signal/bruit**

La possibilité de concevoir un point élémentaire avec les caractéristiques suivantes :

- un nombre limité de transistors MOS ;
- des transistors MOS de même type ;
- les charges stockées dans le canal d'un transistor MOS améliore de manière significative le rendement technologique car le nombre de contacts et d'interconnexions dans le point élémentaire diminue de manière significative pour les raisons suivantes :
- il n'est pas nécessaire d'interconnecter les drain et source de certains transistors MOS de même type à l'aide de prises de contact et d'interconnexions métalliques car ceci peut être réalisé au moyen des diffusions utilisées pour réaliser les diodes de source et drain ;
- il n'est pas nécessaire de respecter les règles de "latch-up", c'est-à-dire de connecter le substrat à l'alimentation Vss et le caisson à l'alimentation Vdd au moyen de contacts et interconnexions métalliques diverses car il n'est pas obligatoire d'implanter des transistors MOS complémentaires dans le point élémentaire ;
- il n'est pas nécessaire de respecter les règles d'espacement entre transistors NMOS et PMOS dans le point élémentaire, car il n'est pas obligatoire d'implanter des transistors MOS complémentaires dans le point élémentaire ;

- il n'est pas nécessaire d'implanter un dispositif de remise à zéro dans le point élémentaire.

Ces mêmes arguments techniques montrent que le taux de remplissage du point élémentaire de la solution proposée est supérieur ou égal à celui des autres solutions où le courant est intégré dans le point élémentaire. Pratiquement, la surface du condensateur de stockage qu'il est possible de dessiner dans le point élémentaire de la solution proposée est supérieure (dans des applications à pas réduit, la surface de stockage est au moins multipliée par un facteur deux) à celle qu'il serait possible de dessiner dans une architecture de type DTC ou bien à suiveurs commutés car le nombre de transistors MOS à y implanter est plus petit. Enfin, on peut montrer que l'excursion de potentiel dans le transistor MOS de stockage est supérieure à celle obtenue dans un point élémentaire de type suiveur commuté.

Par voie de conséquence, la charge stockable de la solution proposée, donc le rapport signal sur bruit du circuit, est supérieure à celle qu'il est possible d'atteindre en employant les solutions de l'art antérieur, toutes conditions opérationnelles (par exemple de taille, de pas des points élémentaires, de température, etc..) étant égales par ailleurs.

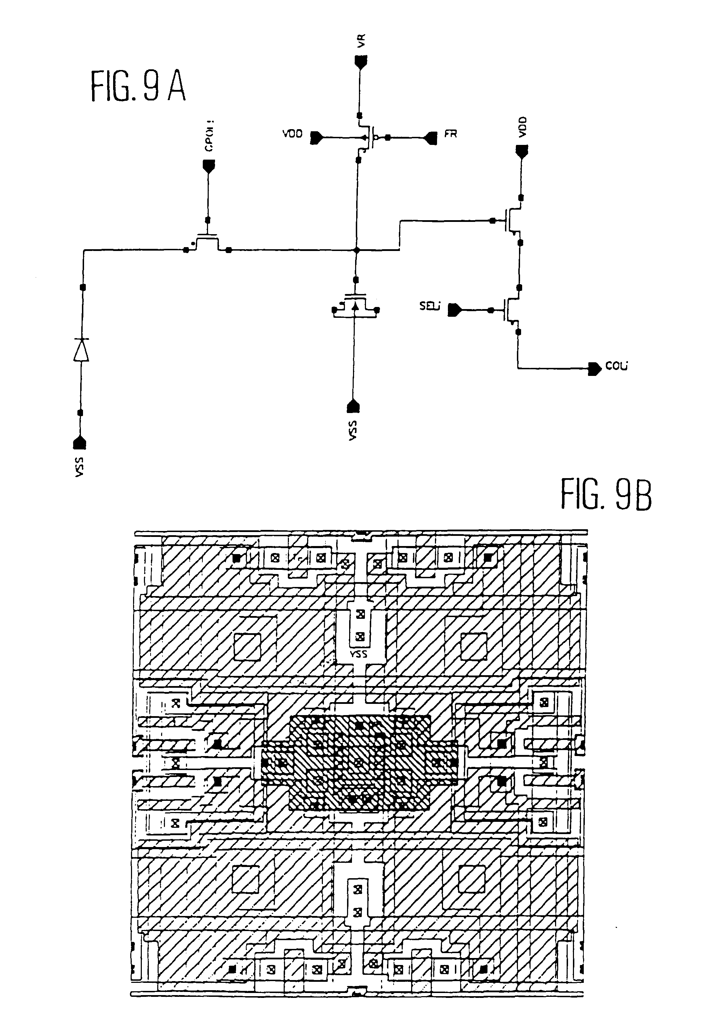

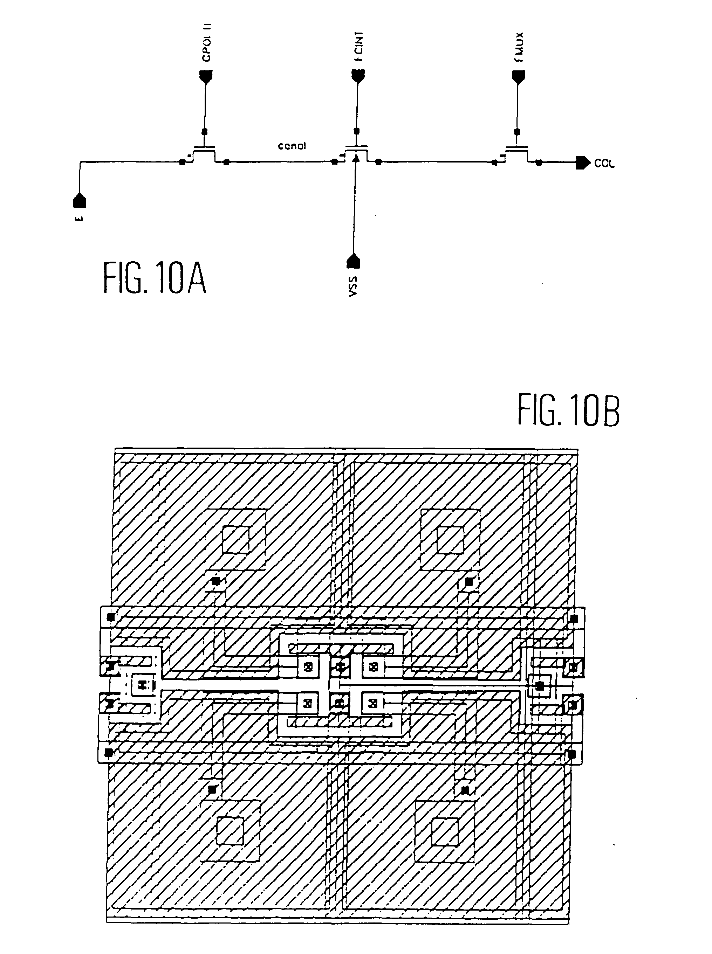

Ceci est illustré sur les figures 9A et 9B, et 10A et 10B, où une mosaïque de deux lignes par deux colonnes de points élémentaires de type suiveur commuté est comparée respectivement à une mosaïque de même format de points élémentaires de type SCA. Les schémas électriques des deux points élémentaires sont représentés au-dessus de l'implantation de ces motifs. Ces deux implantations montrent clairement, à règles de dessin constantes, que celle de l'architecture SCA est nettement plus simple que celle du suiveur commuté. L'homme de l'art y constate en particulier que la solution SCA est nettement supérieure à la solution de type suiveur commuté en terme de :

- densité d'interconnexion;
- de nombre de contacts ;
- taux de remplissage (surface active/surface du point élémentaire).

**Conversion analogique-numérique dans le plan focal**

Les avantages et les applications ouvertes par la conversion analogique-numérique dans le plan focal sont nombreux :

- à partir de ces valeurs numériques présentes, il est possible d'envisager un prétraitement du signal dans le plan focal en vue d'améliorer les performances de celui-ci (moyennage des données, effet TDI, etc ...) ;
- la numérisation des informations permet de ne plus limiter la dynamique des signaux traités aux dynamiques analogiques gérables en sortie d'un plan focal. Ceci devrait améliorer les performances de certains dispositifs ou bien, simplifier le traitement en sortie du plan focal où il était nécessaire dans certaines applications de post-accumuler les différentes informations issus d'un détecteur afin de récupérer l'ensemble de sa dynamique initiale non gérable par le plan focal ;
- la numérisation des informations permet de véhiculer des signaux numériques dans des environnements électromagnétiques très perturbés là où des signaux analogiques auraient été fortement dégradés.

**Réjection des alimentations et des phases de commande**

La solution proposée est nettement supérieure à celle des suiveurs commutés car il n'y a plus d'alimentation critique dans le point élémentaire, aussi bien au niveau de la réinitialisation du point élémentaire, que des alimentations du suiveur.

Par ailleurs, le potentiel de chaque bus colonne est maintenu constant par le dispositif de remise en forme alors que dans les circuits de type suiveurs commutés ou partition sur bus colonne, ce potentiel varie énormément. Cette caractéristique limite les couplages capacitifs entre les différentes fonctions implantées dans le point élémentaire. Ce point est très important car la plupart des noeuds électriques du point élémentaire sont à haute impédance, donc très sensibles, et que ces couplages vont augmenter lorsque le pas des détecteurs va diminuer.

Enfin, il est important de noter que dans une architecture SCA, les condensateurs de stockage sont réinitialisés ligne après ligne, et non pas simultanément comme dans d'autres solutions, ce qui a pour effet de minimiser les appels de courant dans les alimentations, et par voie de conséquence de relâcher les contraintes sur les résistances des bus d'alimentation.

**Dispersions spatiales**

Dans la solution proposée, les dispersions des paramètres de la technologie ne sont pas critiques dans le point élémentaire. Il suffit que la charge stockable dans le condensateur de stockage soit suffisamment grande.

**Lecture/écriture**

Les connexions, les interrupteurs et la logique de commande de cette architecture assurent une continuité électrique, c'est-à-dire une connexion de résistance finie, entre les point élémentaires d'une même colonne et les extrémités du bus de la colonne considérée.

Elles permettent donc, non seulement de lire l'information stockée dans les points élémentaires, mais aussi d'adresser individuellement ces points élémentaires afin d'y injecter un courant et/ou une tension. Autrement dit, par comparaison aux mémoires digitales, cette architecture est de type lecture-écriture et non pas lecture uniquement.

Le mode écriture est utilisable en l'occurrence pour contrôler certains opérateurs implantés dans le point élémentaire de façon à modifier la fonction de transfert de chaque point élémentaire, indépendamment les uns des autres, et ce de manière adaptative en cours de fonctionnement, si besoin est.

On peut prendre comme exemple d'application un circuit de lecture dit à "ébasage en courant" (voir la référence [10]). Dans ce type de circuit, un courant est soustrait à celui de chaque détecteur avant intégration dans le point élémentaire, ce qui permet de minimiser la charge à stocker. Cette soustraction est réalisée au moyen d'un transistor MOS opérant en régime de saturation. Pratiquement, le courant ébasé dans chaque point élémentaire est réglé en présentant une scène uniforme devant le détecteur. Cette calibration optoélectrique pourrait être remplacée par une calibration purement électrique grâce au mode d'écriture.

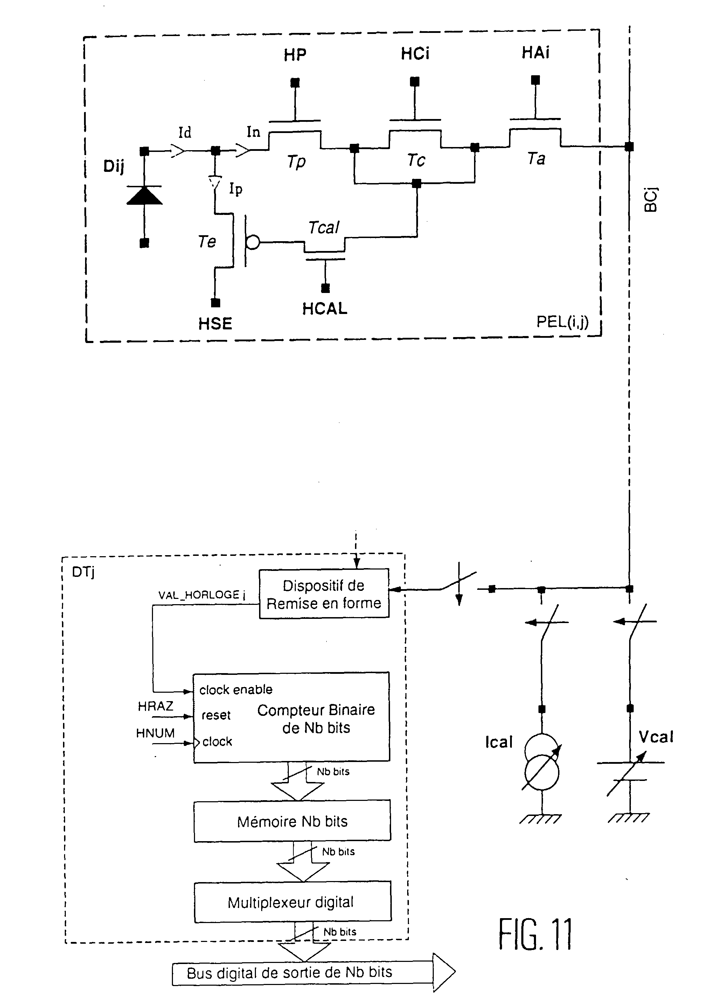

En effet, l'architecture proposée permet d'injecter soit un courant , soit une tension dans chaque point élémentaire. Ceci est illustré sur la figure 11. Le générateur de courant variable (Ical), ou bien la source de tension variable (Vcal), sont commutés sur les bus colonnes au moyen d'un démultiplexeur convenablement séquencé. Le courant ébasé par le transistor PMOS Te intégré dans le point élémentaire pourrait donc être réglé soit en recopiant Ical dans le transistor Te par des techniques de miroir de courant ou autres, soit en échantillonnant-bloquant sur la grille du transistor Te une tension Vcal telle que le courant ébasé soit égal à la valeur voulue.

On conçoit alors qu'il est possible de procéder à des calibrations du circuit en venant modifier, selon les besoins de l'application et de manière indépendante pour chaque point élémentaire, l'intensité du courant ébasé. Les potentialités d'un tel type de calibration sont :

- diminution, voire suppression des prises de références optoélectriques ;
- réglage du courant ébasé dans chaque point élémentaire en fonction de l'évolution de l'éclairement reçu par le circuit de détection.

La testabilité des circuits de lecture dessinés dans un pas réduit, qui est souvent limitée car l'introduction d'un transistor MOS spécifique, se fait au détriment de la charge stockable, donc de la performance de la caméra.

Dans le cadre d'une architecture de type SCA, il apparaît sur la figure 11 qu'il est possible d'injecter dans le point élémentaire une tension et/ou un courant, ce qui résout le problème. Il est fort possible qu'il soit alors nécessaire de modifier le niveau haut appliqué à la grille du transistor MOS d'adressage, mais cela est facilement réalisable par l'homme de l'art.

**Multi-applications**

Du fait que le transistor MOS situé dans le point élémentaire ne sert que de réservoir, il est clair qu'il suffit de réaliser le plus gros transistor MOS dans la place impartie au point élémentaire. Sa quantité de charges maximale stockable détermine d'une part les temps de pose maximum possibles en fonction des courants issus des différents détecteurs envisagés, et d'autre part la dynamique potentiellement gérable par le dispositif, cette dynamique dimensionnant le compteur binaire à savoir:

- son nombre de bits : $Nb^{max}$ ;
- sa cadence de fonctionnement maximale ; $F_{NUM}^{max}$ ;

$Nb^{max}$ et $F_{NUM}^{max}$ sont calculés à partir des équations décrites précédemment.

Pour des applications à dynamique plus faible que celle traitable par le circuit, celui-ci fonctionne correctement sans qu'il soit nécessaire de modifier la cadence de l'horloge $Nb^{max}$ (= $F_{NUM}^{max}$) ni modifier le réglage des taux de variation du temps de descente des horloges HCi.

Cependant pour des applications utilisants des détecteurs qui délivrent en sortie des points élémentaires des impulsions de durée maximale $\delta T_{ij}^{max}$ très inférieure à la durée du front de descente de l'horloge HCi, il semble judicieux de réoptimiser le taux de variation du temps de descente de l'horloge HCi afin d'allonger la durée des impulsions, ce qui permet de réduire la cadence de l'horloge HNUM des compteurs et donc par conséquent de réduire la consommation du dispositif. Tout ceci n'étant que des réglages donc ne modifiant en rien l'architecture du dispositif.

Le schéma de principe d'un tel circuit multi-applications est donc le même que celui de l'architecture standard. Autrement dit, l'architecture standard proposée permet de s'adapter à toutes les applications de lecture de détecteurs qui ont une dynamique inférieure ou égale à celle stockable dans les points élémentaires de l'architecture (le reste de la chaîne de traitement étant dimensionné en conséquence).

Il s'avère donc que l'architecture proposée est très versatile. Cette versatilité ne peut être retrouvée dans les solutions de type dispositifs à transfert de charges ou partition sur le bus colonne qui doivent toujours être utilisées avec le même niveau de charges. Elle n'est non plus pas retrouvée dans les architectures à suiveurs commutés, car bien qu'il soit potentiellement possible d'implanter plusieurs condensateurs dans ce type de point élémentaire, il s'avère que ceci n'est généralement pas réalisable pour cause de manque de place.

## Multi-spectralités

On peut considérer cette application comme un sous-paragraphe des multi-applications et donc prouver par le même raisonnement la versatilité de l'architecture proposée pour ce genre d'applications.

## Barrettes balayées à lecture TDI

Il existe une catégorie de caméras où l'image est formée en balayant optiquement une mosaïque de détecteurs. Le nombre de lignes de cette mosaïque est fonction du format de l'image et son nombre de colonnes est tel qu'il permette d'améliorer le rapport signal sur bruit de la caméra. Ceci est obtenu en sommant à des instants retardés et synchrones du balayage optique les informations délivrées par les détecteurs d'une même ligne de la mosaïque (ce mode de lecture des informations est désigné par "Time Delay Integration" dans la littérature anglaise).

L'architecture proposée est une solution potentielle au problème de lecture de ce type de mosaïque, surtout lorsque le nombre de colonnes et le pas des détecteurs sont petits.

En effet, dans un circuit de lecture de ce type, le courant des détecteurs est tout d'abord transformé en charge, dans le pas des détecteurs si nécessaire.

Il est alors possible, en séquençant convenablement les horloges connectées aux grilles des condensateurs de stockage de lire les charges stockées dans les points élémentaires d'une ligne en les injectant successivement, c'est-à-dire colonne après colonne, sur un même bus ligne.

Ce bus ligne est relié au dispositif de remise en forme qui valide l'horloge HNUM du compteur binaire qui doit aussi être prépositionnable dans le cas présent. Les Nb bits de sortie du compteur et ses Nb bits de prépositionnement sont reliés à un plan mémoire de M mots binaires de Nb bits, M étant le nombre de scènes intermédiaires qu'il faut stocker en vue de la reconstitution des scènes après l'effet TDI sur l'ensemble des détecteurs d'une même ligne.

L'effet TDI est obtenu en prépositionnant le compteur à la somme intermédiaire associée aux détecteurs de la scène déjà lus, avant de valider l'horloge par l'impulsion issue du dispositif de remise en forme associée au détecteur actuellement lu.

A la fin de chaque conversion analogique-numérique (avec sommation instantanée) de l'impulsion associée au détecteur lu, le nouveau résultat en sortie du compteur est :

- soit transféré sur le bus numérique de sortie du circuit de lecture dans le cas où l'impulsion numérisée est celle du dernier détecteur associé à la scène ;
- soit remémorisé dans la mémoire en attendant la sommation avec le détecteur suivant associé à la scène.

Le nombre des mots binaires de la mémoire M et la cadence de l'horloge HNUM sont fonction du nombre de colonnes et d'autres caractéristiques de la caméra.

On a donc une architecture qui réalise la sommation de manière numérique contrairement aux autres solutions proposées par l'état de l'art actuel où la sommation est réalisée de manière analogique.

Le type de sommation impose le même type de mémorisation afin de réaliser la sommation retardée entre les informations issues des détecteurs d'une même scène. La solution proposée permet donc de mémoriser numériquement les résultats intermédiaires d'une scène avant que celle-ci n'ait été vue par l'ensemble des détecteurs.

La plupart des circuits de lecture de type TDI sont réalisés en filière CCD ("Charge-Coupled Device"). Ils donnent des résultats satisfaisants, mais la disponibilité de ces filières et leurs densités d'intégration posent des problèmes, surtout si l'on veut réaliser un TDI sur un grand nombre de colonnes et dans un faible pas.

A partir d'une filière CMOS, on a réalisé une architecture qui réalise les fonctions principales des TDI de manière numérique à savoir la sommation par l'intermédiaire d'un compteur binaire prépositionnable et la mémorisation par l'intermédiaire d'une mémoire logique. Dans l'hypothèse d'une conversion analogique-numérique supposée parfaite la sommation retardée réalisée numériquement n'entraîne pas de dégradation ni de déformation du résultat. De plus, ces différentes cellules numériques sont facilement réalisables, alors que les cellules analogiques équivalentes doivent être capables de gérer analogiquement les informations sans les dégrader par leur bruit associé et sans les distordre à cause de la non-linéarité de leur fonction de transfert.

Les circuits de lecture de type barrettes balayées à lecture TDI réalisés en filière CCD et ceux réalisés dans des architectures classiques en CMOS souffrent donc des mêmes limitations que leurs homologues conçus pour lire les mosaïques de détecteurs non balayées.

Les circuits de lecture de type TDI font donc partie du domaine d'application de l'architecture proposée pour les mêmes raisons que les circuits de lecture précédemment exposés.

Applications industrielles

Les applications potentielles du type d'architecture proposée sont la réalisation de circuits adaptés à la lecture de l'information délivrées par des détecteurs quantiques et des détecteurs thermiques agencés de manière matricielle, essentiellement quand l'utilisation requiert un temps de pose identique et synchrone pour l'ensemble des détecteurs.

De par son concept, ce circuit est particulièrement polyvalent. Autrement dit, un même circuit de lecture peut être utilisé pour des applications relativement différentes, ce qui diminue le coût de développement et le coût de production.

Ce type de circuit de lecture ne nécessite pas de filière spécifique. Bien au contraire, il s'appuie sur les filières analogiques développées pour le traitement du signal.

L'augmentation du taux de remplissage du point élémentaire devrait permettre de développer en utilisant des filières couramment utilisées, des imageurs plus performants en terme de :

- charge stockable, à pas donné ;
- fonctions supplémentaires (on peut citer comme exemples de fonctions l'ébasage en courant, la diminution de l'impédance d'entrée, l'augmentation de la bande passante d'entrée. Les dispositifs à implanter pour synthétiser ces fonctions sont connus de l'homme de l'art) implantées dans le point élémentaire, à charge stockable et à pas donné ;
- pas réduit, à charge stockable donnée.

L'architecture proposée est compatible avec un adressage aléatoire des points élémentaires. Elle permet donc de réaliser une/des sous-images à l'intérieur de l'image. Il est clair que vu la versatilité du circuit, il permet de modifier le temps de pose et/ou la fréquence de sortie des sous-images, tout en conservant un rapport signal sur bruit optimum.

Dans certaines applications, les caméras peuvent faire l'objet de contre-mesure comme un éblouissement par laser. Dans le cas d'une agression par un laser pulsé, l'architecture SCA peut être utilisée comme contre-contre-mesure en utilisant le fait qu'elle peut s'accommoder très facilement de deux temps de pose très différents, tout en conservant sa sensibilité. En effet, en changeant de manière plus ou moins aléatoire le temps de pose sur le circuit de lecture, il est possible de continuer à voir la cible entre deux impulsions. Ceci peut être envisagé avec l'architecture proposée car il suffit de dimensionner le condensateur de stockage et le compteur binaire pire-cas.

Ce circuit apporte une solution à la lecture des circuits de détection de type multicolore. En effet, les détecteurs de ces circuits présentent la particularité de délivrer un courant différent selon la gamme spectrale qu'ils détectent. Il est alors clair qu'il suffit d'avoir autant de transistors MOS dans le point élémentaire et un compteur binaire dimensionné pour la plus grande dynamique traitée pour répondre de manière optimum avec le même circuit de lecture à des détecteurs observant des gammes de longueurs d'onde différentes. Il est possible, par l'intermédiaire de réglages extérieurs, d'optimiser éventuellement la cadence de fonctionnement du compteur binaire en fonction de dynamique propre à une gamme observée afin de minimiser la consommation du dispositif.

Enfin, la conversion analogique-numérique dans le plan focal ouvre de nouvelles applications telles que le pré-traitement des informations dans le plan focal, l'augmentation des dynamiques des signaux sortie du plan focal et ce, indépendamment des perturbations éventuelles dues à l'environnement électromagnétique ou bien la simplification du traitement des données issues du plan focal.

REFERENCES

[1] "256 x 256 PACE-1 PV HgCdTe focal plane arrays for medium and short wavelength infrared applications" de L.J. Kozlowski, K. Vural, V.H. Johnson, J.K. Chen, R.B. Bailey et D. Bui; et de M.J. Gubala et J.R. Teague (SPIE vol. 1308 Infrared Detectors and Focal Plane Arrays, 1990).

**EP 0 749 233 B1**

[2] "Status and direction of PACE-I HgCdTe FPAs for astronomy" de L.J. Kozlowski, K. Vural, D.Q. Bui, R.B. Bailey, D.E. Cooper et D.M. Stephenson (SPIE Vol. 1946 Infrared Detectors and instrumentation, 1993).

[3] "Evaluation of the SBRC 256 x 256 InSb focal plane array and preliminary specifications for the 1024 x 1024 InSb focal plane array" de A.M. Fowler et J. Heynssens (SPIE Vol. 1946 infrared Detectors and Instrumentation, 1993)

[4] "p-channel MIS double-metal process InSb monolithic unit cell for infra-red imaging" de A. Kepten, Y. Shacham-Diamand et S.E. Schacham (SPIE Vol. 1685 Infrared Detectors and Focal Plane Arrays 11,1992)

[5] "Practical design considerations in achieving high performance from infrared hybrid focal plane arrays" de R. A. Ballingall et I.D. Blenkinsop ; et de I.M. Baker et J. Parsons (SPIE Vol. 819 Infrared Technology XIII, 1987).

[6] "High-performance 5-μm 640 x 480 HgCdTe-on-sapphire focal plane arrays" de L.J. Kozlowski, R.B. Bailey, S. A. Cabelli, D.E. Cooper, I.S. Gergis, A. Chi-yi Chen, W.V. McLevige, G.L. Bostrup, K. Vural, W.E. Tennant, et de P.E. Howard (Optical Engineering 33(1), 54-63, Janvier 1994)

[7] "Design of a low-light-level image sensor with on-chip sigma-delta analog-to-digital conversion" de S.R. Mendis, B. Pain, R.H. Nixon et E.R. Fossum (SPIE 1900, page 31).

[8] "Approaches and analysis for on-focal-plane analog-to-digital conversion" de B. Pain, E.R. Fossum (SPIE, volume 2226, Infrarea Readout Electronics II, 1994, page 208.

[9] "On-focal plane analog-to-digital conversion with detector gain and offset compensation" de D.E. Ludwig, N. D. Woodall et MM. Spanish (SPIE volume 1097, Materials, Devices, Techniques and Applications for Z-Plane Focal Plane array (FPA) Technology, 1989, pages 73 à 84).

[10] Demande de brevet français numéro 8810375 "Système de détectiion d'informations sous forme de rayonnement électromagnétique et de lecture des informations détectées"

**Revendications**

1. Dispositif de numérisation pour au moins un détecteur photosensible (DET(i,j)) qui délivre un courant dont l'intensité varie en fonction du flux incident, le temps de pose étant identique et synchrone pour tous les détecteurs, caractérisé en ce qu'il comprend un ensemble de points élémentaires (PEL(i,j)) permettant de lire les signaux délivrés par chaque détecteur, chaque point élémentaire réalisant une préintégration du courant délivré par un détecteur correspondant de façon à générer une quantité de charge, et au moins une chaîne de traitement de l'information comprenant un dispositif de remise en forme effectuant une lecture de la quantité de charges résultante sous forme d'une impulsion de courant, de manière à conditionner les signaux délivrés par les détecteurs ; les signaux issus de la (ou des) chaîne(s) de traitement étant multiplexés vers des moyens générant au moins une sortie numérique.

2. Dispositif selon la revendication 1, caractérisé en ce que les détecteurs photoniques sont choisis dans le groupe comprenant des détecteurs quantiques et des détecteurs thermiques.

3. Dispositif selon la revendication 1, caractérisé en ce que les détecteurs sont réalisés sur un autre substrat que ledit dispositif de lecture.

4. Dispositif selon la revendication 1, caractérisé en ce que le détecteurs sont réalisés directement sur le circuit du dispositif de lecture.

5. Dispositif selon la revendication 1, caractérisé en ce qu'il comprend un ensemble de points élémentaires (PEL(i, j)) répartis en lignes et en colonnes de manière à décrire une matrice, en ce que les points élémentaires (PEL(i, j)) d'une même colonne ont une connexion commune appelée bus-colonne (BCj) et en ce que chaque bus-colonne est relié à une chaîne de traitement comprenant les moyens suivants :

   - un dispositif de remise en forme du signal apte à lire et à convertir l'impulsion de courant issus d'un point élémentaire en un signal de type binaire, pendant une seconde horloge (HCi) de façon simultanée, et ceci pour chaque point d'une même ligne, les lignes étant traitées les unes après les autres ;

- un compteur muni d'une quatrième horloge (HNUM) qui compte les coups d'horloge pendant toute la durée du signal issu du dispositif de remise en forme;
- un dispositif de lecture du signal numérisé.

**6.** Dispositif selon la revendication 5, caractérisé en ce que chaque point élémentaire comprend ;

- un dispositif d'adaptation d'impédance muni d'une première horloge (HP), apte à polariser le détecteur et à lire le courant fourni par le détecteur ;
- au moins d'un transistor MOS, muni de la seconde horloge (HCi) apte d'une part à intégrer le courant fourni par le détecteur, d'autre part à stocker la charge obtenue et enfin, associé à un dispositif d'adressage, à évacuer cette charge sous forme d'une impulsion de courant sur un dispositif de remise en forme du courant qui transforme cette impulsion de courant en un signal de type binaire, ce dispositif de remise en forme étant extérieur au point élémentaire ;
- le dispositif d'adressage, muni d'une troisième horloge (HAi), apte à commuter la source et/ou le drain du transistor MOS sur un bus-colonne.

**7.** Dispositif selon la revendication 6, caractérisé en ce que le dispositif d'adaptation d'impédance est relié par son entrée au détecteur, par sa sortie à la source et/ou au drain du transistor MOS et par sa commande à la première horloge (HP) qui commute entre une tension de blocage et une tension de polarisation, et en ce que la grille du transistor MOS est relié à la seconde horloge (HCi) qui, commutée à une certaine tension, permet l'évacuation de la charge stockée sur une connexion commune et, commutée à une autre tension, intègre le courant issu du détecteur et stocke la charge obtenue ; en ce que le dispositif d'adressage est relié par son entrée à la source et/ ou au drain du transistor MOS, par sa sortie au bus-colonne et par sa commande à une troisième horloge (HAi) qui commute entre une tension de blocage et une tension pour laquelle le dispositif d'adressage est passant; en ce que le dispositif de remise en forme du courant est connecté en entrée au bus-colonne et en sortie au compteur; et, en ce que le compteur est connecté en sortie au dispositif de lecture de signal numérisé.

**8.** Dispositif selon la revendication 7, caractérisé en ce qu'un dispositif de stockage des données est connecté entre le compteur et le dispositif de lecture de signal numérisé.

**9.** Dispositif selon la revendication 8, caractérisé en ce que le dispositif de stockage est une mémoire RAM.

**10.** Dispositif selon la revendication 5, caractérisé en ce que le dispositif de remise en forme du signal est un amplificateur courant/tension.

**11.** Dispositif selon la revendication 6, caractérisé en ce que le dispositif d'adaptation d'impédance est un transistor MOS(Tp).

**12.** Dispositif selon la revendication 5, caractérisé en ce que dans le cas d'une barrette de détecteurs, il n'y a pas de connexion commune, il y a autant de dispositif de remise en forme du signal et de compteurs que de lignes dans la barrette, le multiplexage étant limité au multiplexage des compteurs.

**13.** Procédé de lecture de détecteurs photosensibles, mettant en oeuvre le dispositif selon l'une quelconque des revendications 1 à 12, caractérisé en ce qu'il comporte les étapes suivantes :

- une conversion du courant du détecteur en charge par intégration d'une durée égale au temps de pose ;
- une conversion de la charge intégrée en une impulsion de courant dont :

  • l'amplitude est constante pour tous les détecteurs et ajustable en fonction d'un stimulus,
  • la durée varie proportionnellement en fonction de la charge stockée ;

- une conversion de la largeur de cette impulsion de courant en une valeur numérique au moyen d'un compteur binaire.

**14.** Procédé selon la revendication 13, caractérisé en ce qu'il comporte les étapes suivantes :

- une première étape de prise d'image pendant laquelle un première horloge (HP) commune à tous les dispositifs d'adaptation d'impédance de tous les points élémentaires est au niveau de la tension de polarisation (Vpol), les horloges propres à chaque ligne (HCi), i étant le numéro de la ligne, sont au niveau de tension permettant le stockage des charges et les horloges propres à chaque ligne (HAi) sont à une tension de blocage : une fois par image il y a intégration du courant fourni par le détecteur dans le transistor MOS pendant un temps prédéfini, ceci se passant pour tous les détecteurs simultanément ;
- une seconde étape pendant laquelle la première horloge (HP) revient au niveau de la tension de blocage ; pour chaque ligne la seconde horloge (HCi) varie de façon linéaire depuis le niveau permettant le stockage des charges jusqu'au niveau bloquant le transistor, et la troisième horloge (HAi) commute à un certain niveau (Vécran) pendant cette variation de la seconde horloge (HCi); pour chaque point élémentaire d'une même ligne il y a évacuation des charges stockées pour chaque ligne de la matrice et simultanément conversion analogique-numérique des charges stockées ;
- une troisième étape de conversion analogique-numérique pendant laquelle la durée du signal de sortie du dispositif de remise en forme de la colonne j est égale à la durée de l'impulsion de courant délivrée sur le bus colonne (BCj) par point élémentaire (PEL(i,j)), pendant la variation de la seconde horloge (HCi) de sa tension de stockage des charges à sa tension de blocage du transistor, elle-même proportionnelle à la quantité de charge stockée sous le transistor MOS du point élémentaire (PEL(i,j)); le compteur logique j réinitialisé au préalable par l'horloge HRAZ compte le nombre de périodes d'horloge HNUM pendant la durée du signal issu du dispositif de remise en forme ;

et en ce que lorsque l'on a balayé toutes les lignes, on recommence les étapes précédentes pour une autre image.

15. Procédé selon la revendication 13, caractérisé en ce qu'il comporte les étapes suivantes :

- une fois par image, intégration du courant fourni par le détecteur dans un dispositif de stockage pendant un temps prédéfini en fonction des conditions d'éclairement de la scène, des caractéristiques du détecteur, de la valeur de la capacité de stockage ;
- étape d'évacuation des charges réalisées pour chaque ligne de la matrice ;
- lorsque l'on a balayé toutes les lignes, on recommence les étapes précédentes pour une autre image.

**Patentansprüche**

1. Digitalisierungsvorrichtung für wenigstens einen lichtempfindlichen Detektor (DET(i,j)), der einen Strom liefert, dessen Stärke in Abhängigkeit vom einfallenden Lichtstrom variiert, wobei die Belichtungszeit für alle Detektoren identisch und synchron ist,
**dadurch gekennzeichnet,** dass sie ein System aus Grundelementen (PEL(i,j)) umfaßt, das ermöglicht, die Signale zu lesen, die durch jeden Detektor geliefert werden, wobei jedes Grundelement eine Vorintegration des durch den entsprechenden Detektor gelieferten Stroms realisiert, um eine Ladungsgröße zu erzeugen, und wenigstens eine Verarbeitungskette der Information, eine Signalaufbereitungseinrichtung umfassend, die ein Lesen der resultierenden Größe von Ladungen in Form eines Stromimpulses durchführt, um die durch die Detektoren gelieferten Signale zu konditionieren, wobei die von der (oder den) Verarbeitungskette(n) stammenden Signale zu Einrichtungen multiplexiert werden, die wenigstens einen digitalen Ausgang erzeugen.

2. Vorrichtung nach Anspruch 1, dadurch gekennzeichnet, dass die Photonendetektoren aus der Gruppe ausgewählt werden, die Quantendetektoren und Thermodetektoren umfaßt.

3. Vorrichtung nach Anspruch 1, dadurch gekennzeichnet, dass die Detektoren auf einem anderen Substrat als die genannte Lesevorrichtung hergestellt werden.

4. Vorrichtung nach Anspruch 1, dadurch gekennzeichnet, dass die Detektoren direkt auf der Schaltung der Lesevorrichtung hergestellt werden.

5. Vorrichtung nach Anspruch 1, dadurch gekennzeichnet, dass sie ein System aus Grundelementen (PEL(i,j)) umfaßt, zu Zeilen und Spalten angeordnet, um eine Matrix zu definieren, dass die Grundelemente (PEL(i,j)) derselben Spalte eine gemeinsame, Spalten-Bus (BCj) genannte Verbindung haben, und dass jeder Spalten-Bus mit einer Verarbeitungskette verbunden ist, die die folgenden Einrichtungen umfaßt:

- eine Signalaufbereitungseinrichtung, fähig den von einem Grundelement stammenden Impuls zu lesen und umzuwandeln in ein Signal des binären Typs, wobei während eines zweiten Taktes (HCi) simultan, und dies für jeden Punkt einer selben Zeile, die Zeilen nacheinander verarbeitet werden;
- eine Zähleinrichtung, versehen mit einem vierten Takt (HNUM), der die Taktschläge bzw. -impulse während der gesamten Dauer des von der Signalaufbereitungseinrichtung stammenden Signals zählt;
- eine Leseeinrichtung des digitalisierten Signals.

6. Vorrichtung nach Anspruch 5, dadurch gekennzeichnet, dass jedes Grundelement umfaßt:

- eine Impedanzanpassungseinrichtung, versehen mit einem ersten Takt (HP), fähig den Detektor zu polen bzw. vorzuspannen und den durch den Detektor gelieferten Strom zu lesen;
- wenigstens einen MOS-Transistor, versehen mit einem zweiten Takt (HCi), fähig, einerseits den durch den Detektor gelieferten Strom zu integrieren, andererseits die erhaltene Ladung zu speichern, und schließlich, in Verbindung mit einer Adressiereinrichtung, diese Ladung in Form eines Stromimpulses in eine Aufbereitungseinrichtung des Stroms zu entleeren, die diesen Stromimpuls in ein Signal des binären Typs umwandelt, wobei diese Aufbereitungseinrichtung sich außerhalb des Grundelements befindet;
- die Adressiereinrichtung, versehen mit einem dritten Takt (HAi), fähig die Source und/oder den Drain des MOS-Transistors auf einen Spalten-Bus zu schalten.

7. Vorrichtung nach Anspruch 6, dadurch gekennzeichnet, dass die Impedanzanpassungseinrichtung durch ihren Eingang mit dem Detektor verbunden ist, durch ihren Ausgang mit der Source und/oder dem Drain des MOS-Transistors und durch ihre Steuerung mit dem ersten Takt (HP), der zwischen einer Sperrspannung und einer Polungs- bzw. Vorspannung umschaltet, und dadurch, dass das Gate des MOS-Transistors mit dem zweiten Takt (HCi) verbunden ist, der, auf eine bestimmte Spannung geschaltet, die Entleerung der gespeicherten Ladung in einen gemeinsamen Anschluß ermöglicht und, auf eine andere Spannung geschaltet, den von dem Detektor stammenden Strom integriert und die erhaltene Ladung speichert; dass die Adressiereinrichtung durch ihren Eingang mit der Source und/oder dem Drain des MOS-Transistors verbunden ist, mit ihrem Ausgang mit dem Spalten-Bus, und durch ihre Steuerung mit einem dritten Takt (HAi), der zwischen einer Sperrspannung und einer Spannung umschaltet, bei der die Adressiereinrichtung durchlässig ist; dass die Stromaufbereitungseinrichtung mit dem Eingang mit dem Spalten-Bus verbunden ist und mit dem Ausgang mit der Zähleinrichtung; und dadurch, dass die Zähleinrichtung mit dem Ausgang mit der Leseeinrichtung des digitalisierten Signals verbunden ist.

8. Vorrichtung nach Anspruch 7, dadurch gekennzeichnet, dass eine Datenspeichereinrichtung eingeschaltet ist zwischen die Zähleinrichtung und die Leseeinrichtung des digitalisierten Signals.

9. Vorrichtung nach Anspruch 8, dadurch gekennzeichnet, dass die Speichereinrichtung ein RAM ist.

10. Vorrichtung nach Anspruch 5, dadurch gekennzeichnet, dass die Signalaufbereitungseinrichtung ein Strom-/Spannungsverstärker ist.

11. Vorrichtung nach Anspruch 6, dadurch gekennzeichnet, dass die Impedanzanpassungseinrichtung ein MOS-Transistor (Tp) ist.

12. Vorrichtung nach Anspruch 5, dadurch gekennzeichnet, dass es im Falle einer Detektorenanordnung, wenn es keine gemeinsame Verbindung gibt, ebensoviele Signalaufbereitungseinrichtungen und Zähleinrichtungen wie Zeilen in der Anordnung gibt, wobei das Multiplexieren auf das Multiplexieren der Zähleinrichtung beschränkt ist.

13. Leseverfahren lichtempfindlicher Detektoren, das die Vorrichtung nach einem der Ansprüche 1 bis 12 benutzt, **dadurch gekennzeichnet,** dass es die folgenden Schritte umfaßt:

- eine Umsetzung des Stroms des Detektors in Ladung durch Integration einer Zeitdauer gleich der Belichtungszeit;
- eine Umsetzung der integrierten Ladung in einen Stromimpuls:

  . dessen Amplitude bei allen Detektoren konstant ist und anpaßbar in Abhängigkeit von einem Stimulus,
  . dessen Dauer sich in Abhängigkeit von der gespeicherten Ladung proportional verändert.

**EP 0 749 233 B1**

- eine Umsetzung der Breite dieses Stromimulses mittels einer binären Zähleinrichtung in einen digitalen Wert.

**14.** Verfahren nach Anspruch 13, dadurch gekennzeichnet, dass es die folgenden Schritte umfaßt:

- einen ersten Schritt zur Bildaufnahme, während dem ein erster, allen Impedanzanpassungseinrichtungen aller Grundelemente gemeinsamer Takt (HP) sich auf dem Niveau der Polungs- bzw. Vorspannung (Vpol) befindet, die jeder Zeile eigenen Takte (HCi), wobei i die Nummer der Zeile ist, sich auf dem Spannungsniveau befinden, das die Speicherung der Ladungen ermöglicht, und die jeder Zeile eigenen Takte (HAi) sich auf einer Sperrspannung befinden und es einmal pro Bild während einer vorher festgelegten Zeit eine Integration des durch den Detektor in den MOS-Transistor gelieferten Stroms gibt, wobei dies sich bei allen Detektoren simultan ereignet;
- einen zweite Schritt, während dem der erste Takt (HP) zur Sperrspannung zurückkehrt; bei jeder Zeile verändert sich der zweite Takt (HCi) linear von dem Niveau, das die Speicherung der Ladungen ermöglicht, bis zu dem Niveau, das den Transistor sperrt, und der dritte Takt (HAi) schaltet während dieser Veränderung des zweiten Takts auf ein bestimmtes Niveau (VBildschirm); bei jedem Grundelement derselben Zeile gibt es für jede Zeile der Matrix eine Entleerung der gespeicherten Ladungen und simultan eine Analog-Digitalumsetzung der gespeicherten Ladungen;
- einen dritten Schritt zur Analog-Digitalumsetzung, während dem die Dauer des Ausgangssignals der Aufbereitungseinrichtung der Spalte j gleich der Dauer des Stromimpulses ist, der auf dem Spalten-Bus (BCj) durch das Grundelement (PEL(i,j)) geliefert wird während der Veränderung des zweiten Takts (HCi) von seiner Speicherspannung der Ladung zu seiner Sperrspannung des Transistors, ihrerseits selbst proportional zu der Größe der unter dem MOS-Transistor des Grundelements (PEL(i,j)) gespeicherten Ladung; die vorher durch den Takt HRAZ reinitialisierte logische Zähleinheit j zählt die Anzahl der Perioden des Takts HNUM während der Dauer des von der Aufbereitungseinrichtung stammenden Signals;

und dadurch, dass man, wenn alle Zeilen abgetastet sind, die vorangehenden Schritte für ein anderes Bild neu beginnt.

**15.** Verfahren nach Anspruch 13, dadurch gekennzeichnet, dass es die folgenden Schritte umfaßt:

- einmal pro Bild eine Integration des durch den Detektor in eine Speichereinrichtung während einer vorher festgelegten Zeit in Abhängigkeit von den Beleuchtungsbedingungen der Szene, der Kenndaten des Detektors und des Werts der Speicherungskapazität gelieferten Stroms;
- Entleerungsschritt der für jede Zeile der Matrix realisierten Ladungen;
- Neubeginn der vorangehenden Schritte für ein anderes Bild, wenn man alle Zeilen abgetastet hat.

**Claims**

**1.** A digitizing device for at least one photosensitive detector (DET(i,j) which supplies a current whose intensity varies as a function of the incident flux, the exposure time being identical and synchronous for all the detectors, characterized in that it includes an assembly of elementary points (PEL(i,j) which allow the signals supplied by each detector to be read, each elementary point carrying out a preintegration of the current supplied by a corresponding detector in a way that generates a quantity of charge, and at least one information processing chain including a regeneration device carrying out a reading of the resultant quantity of charge in the form of a current pulse, in a manner that packages the signals supplied by the detectors; the signals coming from the processing chain(s) being multiplexed towards means generating at least one digital output.

**2.** A device according to claim 1, characterized in that the photonic detectors are chosen from a group comprising quantum detectors and thermal detectors.

**3.** A device according to claim 1, characterized in that the detectors are produced on another substrate to that of the reading device.

**4.** A device according to claim 1, characterized in that the detectors are created directly on the reading device circuit.

**5.** A device according to Claim 1 characterised in that it includes an assembly of elementary points (PEL(i,j)) divided into lines and columns in a manner that describes a matrix, in which the elementary points (PEL(i,j)) in the same column have a common connection called a column bus (BCj) and in which each column bus is connected to a processing chain including the following means:

- a signal regeneration device capable of reading and converting the current pulse coming from an elementary point into a binary type signal during a signal from the second clock, in a simultaneous fashion and doing this for each point in the same line, the lines being processed one after another;
- a counter provided with a fourth clock (HNUM) which counts the clock pulses during the whole duration of the signal from the regeneration device;
- a device for reading the digitised signal.

6. A device according to Claim 5, characterised in that each elementary point includes:

- an impedance matching device, fitted with a first clock (HP) capable of polarising the detector and of reading the current supplied by the detector;
- at least one MOS transistor, provided with a second clock (HCi) capable on the one hand of integrating the current supplied by the detector, and on the other hand of storing the charge obtained, and finally in association with an addressing device, of evacuating this charge, in the form of a current pulse, onto a current regeneration device which transforms this current pulse into a binary type signal, this regeneration device being external to the elementary point;
- the addressing device, provided with a third clock (HAi), capable of switching the source and/or the drain of the MOS transistor onto a column bus.

7. A device according to Claim 6, characterised in that the impedance matching device is connected by its input to the detector, by its output to the source and/or drain of the MOS transistor and by its command to the first clock (HP) which switches between a disabling voltage and a polarisation voltage and in that the gate of the MOS transistor is connected to the second clock (HCi) which switched to a certain voltage allows evacuation of the stored charge onto a common connection and, switched to another voltage, integrates the current coming from the detector and stores the charge obtained; and in that the addressing device is connected, by its input to the source and/or drain of the MOS transistor, by its output to the column bus and by its command to a third clock (HAi) which switches between a disabling voltage and a voltage at which the addressing device is enabled and in that the current regenerating device is connected at its input to the column bus and at its output to the counter, and in that the counter is connected at its output to the device for reading the digitised signal.

8. A device according to Claim 7 characterised in that a data storage device is connected between the counter and the device for reading the digitised signal.

9. A device according to Claim 8 characterised in that the storage device is a RAM.

10. A device according to Claim 5 characterised in that the signal regeneration device is a current/voltage amplifier.

11. A device according to Claim 6 characterised in that the impedance matching device is an MOS(Tp) transistor.

12. A device according to Claim 5 characterised in that in the case of a linear array of detectors, there is no common connection and there are as many signal regeneration devices and counters as lines in the linear array, the multiplexing being limited to the multiplexing of the counters.

13. A method of reading photosensitive detectors, making use of the device according to any one of Claims 1 to 12, characterised in that it comprises the following steps:

- a conversion of the current from the detector into charge by integration of a duration equal to the exposure time;
- a conversion of the integrated charge into a current pulse whose:

   • amplitude is constant for all the detectors and adjustable in relation to a stimulus,
   • duration varies proportionately as a function of the stored charge;

- a conversion of the width of this current pulse into a digital value using a binary counter.

14. A method according to Claim 13, characterised in that it comprises the following steps:

- a first step of taking an image during which a first clock (HP) common to all the impedance matching devices of all the elementary points is at the level of the polarisation voltage (Vpol), the clocks (HCi) belonging to each line, i being the number of the line, are at the voltage level allowing the storage of charge and the clocks HAi belonging to each line are at a disabling voltage: one time per image, there is an integration of the current supplied by the detector in the MOS transistor during a predefined time, this occurring for all the detectors simultaneously;

- a second step, during which the first clock (HP) returns to the disabling voltage level; for each line, the second clock (HCi) changes, in a linear fashion, from its charge storage voltage to a transistor disabling voltage, and the third clock (HAi) switches to a certain level Vscreen during this change of the second clock (HCi); for each elementary point on the same line, there is an evacuation of the stored charges for each line of the matrix and simultaneously, an analog-digital conversion of the stored charges;

- a third step of analog-digital conversion during which, the duration of the output signal from the regeneration device of the column j is equal to the duration of the current pulse supplied to the column bus (BCj) by elementary point (PEL(i,j)) during the change of the second clock (HCi) from its charge storage voltage to its transistor disabling voltage, itself proportional to the quantity of charge stored under the MOS transistor of elementary point (PEL(i,j)); the logic counter j, previously reinitialised by the clock HRAZ, counts the number of periods of clock HNUM during the duration of the signal coming from the regeneration device;

  and in that when all the lines have been scanned, the preceding steps are started again for another image.

**15.** A method according to Claiml3, characterised in that it comprises the following steps:

- one time per image, integration of the current supplied by the detector in a storage device during a time predefined as a function of the illumination conditions of the scene, the characteristics of the detector, and the value of the storage capacitance;
- a step of evacuating the charges carried out for each line of the matrix;
- when all the lines have been scanned, the preceding steps are started again for another image.

FIG.1A

FIG.1B

FIG. 2A

FIG. 2B

AI

Cpei

DET(i,j)

BCj

PEL(i,j)

## FIG. 3A

PEL
(1,1)

RAZ

PEL
(1,M)

RAZ

BC1

BCM

PEL
(N,1)

PEL
(N,M)

Cbc

Cbc

Abc

Abc

As

Vs

## FIG. 3B

FIG. 4A

FIG. 4B

C

AI

DET(i,j)

BCj

PEL(i,j)

FIG. 5 A

PEL
(1,1)

PEL
(1,M)

FIG. 5 B

BC1

BCM

PEL
(N,1)

PEL
(N,M)

Dispositif de
Remise en forme

Dispositif de
Remise en forme

VAL_HORLOGE 1

VAL_HORLOGE M

HNUM

Compteur Binaire
de Nb bits

HNUM

Compteur Binaire
de Nb bits

Bus digital de sortie de Nb bits

HP HCi HAi

Dij

PEL(i,j)

Tp Tc Ta

Vc(i,j)

BCj

DTj

VAL_HORLOGE j

Dispositif de
Remise en forme

clock enable

HRAZ reset

HNUM clock

Compteur Binaire
de Nb bits

Nb bits

Mémoire Nb bits

Nb bits

Multiplexeur digital

Nb bits

Bus digital de sortie de Nb bits

FIG. 6

FIG. 7

FIG. 8

FIG. 9 A

FIG. 9B

# FIG. 10A

# FIG. 10B

HP    HCi    HAi

Id    In

Dij    Tp    Tc    Ta

Ip

Te    Tcal

HSE    HCAL    PEL(i,j)

BCj

DTj

VAL_HORLOGE i

Dispositif de
Remise en forme

clock enable

HRAZ    reset    Compteur Binaire
de Nb bits

HNUM    clock

Nb bits

Mémoire Nb bits

Nb bits

Multiplexeur digital

Nb bits

Bus digital de sortie de Nb bits

Ical    Vcal

FIG. 11